# EUROPEAN PATENT SPECIFICATION

(11) **EP 2 975 461 B1**
(45) Date of publication and mention of the grant of the patent: **16.08.2017**
(21) Application number: 14762781.4
(22) Date of filing: 05.02.2014
(51) Int. Cl.: G03F 7/32, G03F 7/00

(54) **CONCENTRATING METHOD FOR PLATEMAKING WASTE FLUID AND RECYCLING METHOD**
KONZENTRATIONSVERFAHREN FÜR FLUIDABFÄLLE AUS EINER DRUCKFORMHERSTELLUNG UND RECYCLINGVERFAHREN
PROCÉDÉ DE CONCENTRATION POUR FLUIDE USAGÉ DE CLICHAGE ET PROCÉDÉ DE RECYCLAGE

(30) Priority: 14.03.2013 JP 2013052177
(43) Date of publication of application: 20.01.2016
(73) Proprietor: Fujifilm Corporation, Minato-ku Tokyo 106-8620 (JP)
(72) Inventor: WATANABE, Toshihiro, Haibara-gun, Shizuoka 421-0396 (JP)
(74) Representative: Hoffmann Eitle
(86) International application number: PCT/JP2014/052705
(87) International publication number: WO 2014/141781

(56) References cited:
- EP-A1- 2 482 133
- EP-A1- 2 489 638
- JP-A- H07 171 553
- JP-A- H07 234 524
- JP-A- 2004 070 031
- JP-A- 2008 080 229
- JP-A- 2008 145 983
- JP-A- 2009 069 802
- JP-A- 2009 090 631

## Description

### Technical Field

The present invention relates to a method of concentrating a platemaking waste liquid generated in performing development and desensitization in one step, when the platemaking process of a photosensitive planographic printing plate precursor is carried out using an automatic developing machine, and a recycling method.

### Background Art

Conventionally, in the case of developing a photosensitive planographic printing plate precursor using an automatic developing machine, a means of supplying a replenishment developer to the developer in each of the steps has been employed, in order to maintain constant concentrations of components, which are lost due to the development process or aging of the developer, or a constant pH of the developer, and in order to maintain the performance of the developer. In a case in which the performance of the developer is outside the permissible limit even though such replenishment with a replenishment developer is conducted, the whole developer is discarded as a platemaking waste liquid. Since the platemaking waste liquid is strongly alkaline, the waste liquid cannot be discharged as it is, as ordinary waste water. For this reason, platemaking traders themselves need to carry out waste liquid processing by constructing equipment for processing waste liquids, or by entrusting the task of processing waste liquid to a waste liquid processing company, or the like.

However, the method of entrusting the task to a waste liquid processing company requires a huge space for storage of waste liquids, and requires a lot of money in terms of costs. Further, there are problems in that waste liquid processing facilities require extremely high initial investment costs and a significantly large place for preparation, and the like.

In order to address the above problems, a technique for reducing the amount of waste liquid to be discharged, by lowering the pH of the developer, and further, performing desensitization simultaneously with development at the time of development, has been proposed (Japanese Patent Application Laid-Open (JP-A) No. 2008-233660).

Further, as other techniques for reducing the amount of waste liquid, a method of blowing hot air into a waste liquid storage tank to concentrate waste liquid (JP-A No. H5-341535), a method of neutralizing the waste liquid generated in processing, and adding an aggregating agent to aggregate the aggregation components (JP-A No. H2-157084), and the like have been proposed.

Moreover, an apparatus for reducing the amount of platemaking waste liquid in producing a planographic printing plate has been proposed, with which the discharge amount of the platemaking waste liquid can be reduced, and in which water generated in the course of processing the platemaking waste liquid can be easily reutilized (Japanese Patent No. 4774124).

On the other hand, in connection with the problems related to the waste liquid generated in the development for producing a planographic printing plate, from the viewpoint of the formulation of the developer for producing a planographic printing plate, a technique of using a developer containing a non-reducing sugar and a base has been proposed (JP-A No. 2011-90282). However, under the present circumstances, it cannot be expected to sufficiently address the problems related to the processing of waste liquid, only by changing the formulation of the developer.

### SUMMARY OF INVENTION

### Technical Problem

In the technique of concentrating waste liquid by using hot air, which is described in JP-A No. H5-341535, since the evaporation amount is not large, the effect of reducing the amount of waste liquid is not sufficient, and there is a problem in that a long time is required to sufficiently concentrate the platemaking waste liquid. In addition, investigations have not been made regarding the processing of evaporated moisture.

In the technique of using an aggregating agent, which is described in JP-A No. H2-157084, there is a problem in that processing of waste liquid has high cost. Further, in a case in which the platemaking waste liquid contains a polymer compound, there is a problem in that maintenance is complicated, as the solids remaining inside the evaporation pot become viscous and adhere to the wall surfaces of the evaporation pot, such that the wall surfaces easily become dirty, and the pipes of the waste liquid processing apparatus are likely to be clogged.

The invention has been accomplished in consideration of the above problems, and it is an aspect of the invention to provide a method of concentrating a platemaking waste liquid, according to which foaming at the time of concentrating the waste liquid generated in the platemaking process, in which development and desensitization are carried out in one step using a developer in an automatic developing machine, is suppressed, concentration is efficiently carried out, and washing of the concentration pot or the like can be easily carried out.

Further, another aspect of the invention is to provide a method of recycling a platemaking waste liquid, according to which, by reutilizing the reclaimed water obtained when the platemaking waste liquid is concentrated, the amount of stains due to accumulation of deposits in the developing bath of the automatic developing machine is reduced, and generation of precipitates is suppressed, even in a case in which the platemaking process is carried out continuously for a long time.

### Solution to Problem

As a result of intensive studies in order to address the above problems, it has been found that the above problems can be addressed by using a developer containing a specific surfactant, when development and desensitization are conducted in one step at the time of development, whereby the invention has been completed.

Namely, the configuration of the invention is as follows.
[1] A method of concentrating a platemaking waste liquid generated in processing a photosensitive planographic printing plate precursor, the method including: a platemaking step in which development and desensitization of a photosensitive planographic printing plate precursor, which has, on a support, an image recording layer that contains thermoplastic polymer particles and a photothermal conversion agent and which has undergone exposure with an infrared laser, are conducted in one step in an automatic developing machine, using a developer; a waste liquid concentrating step of evaporating and concentrating the platemaking waste liquid generated in the platemaking step, using a waste liquid concentration unit, such that a ratio of a volume of the platemaking waste liquid after the concentration to a volume of the platemaking waste liquid before the concentration is from 1/2 to 1/10; and a reclaimed water producing step of taking out steam that has been separated in the waste liquid concentrating step from the waste liquid concentration unit, and condensing the steam using a cooling means to produce reclaimed water; in which the developer is a developer which contains at least one surfactant selected from the group consisting of anionic surfactants and nonionic surfactants in an amount of from 1% by mass to 10% by mass, has a content of an organic solvent having a boiling point within a range of from 100°C to 300°C of 2% by mass or lower, and has a content of an organic solvent having a boiling point of lower than 100°C or a boiling point of higher than 300°C of 0.2% by mass or lower.
[2] The method of concentrating a platemaking waste liquid generated in processing a photosensitive planographic printing plate precursor according to [I], wherein the surfactant is an anionic surfactant.
[3] The method of concentrating a platemaking waste liquid generated in processing a photosensitive planographic printing plate precursor according to [2], wherein the anionic surfactant includes a sulfonic acid salt having a diphenyl ether skeleton.
[4] The method of concentrating a platemaking waste liquid generated in processing a photosensitive planographic printing plate precursor according to [3], wherein the developer contains two or more types of sulfonic acid salts having a diphenyl ether skeleton.
[5] The method of concentrating a platemaking waste liquid generated in processing a photosensitive planographic printing plate precursor according to any one of [1] to [4], wherein the organic solvent having a boiling point within a range of from 100°C to 300°C is ethylene glycol, and the content of ethylene glycol with respect to the developer is from 0.1% by mass to 1.0% by mass.
[6] The method of concentrating a platemaking waste liquid generated in processing a photosensitive planographic printing plate precursor according to any one of [1] to [5], wherein the developer contains a water-soluble resin.
[7] The method of concentrating a platemaking waste liquid generated in processing a photosensitive planographic printing plate precursor according to [6], wherein the water-soluble resin is dextrin, and the content of dextrin with respect to the developer is from 1.0% by mass to 5.0% by mass.
[8] The method of concentrating a platemaking waste liquid generated in processing a photosensitive planographic printing plate precursor according to any one of [1] to [7], wherein the pH of the developer is from 6 to 10.
[9] A method of recycling a platemaking waste liquid generated in processing a photosensitive planographic printing plate precursor, the method including: a platemaking step in which development and desensitization of a photosensitive planographic printing plate precursor, which has, on a support, an image recording layer that contains thermoplastic polymer particles and a photothermal conversion agent and which has undergone exposure with an infrared laser, are conducted in one step in an automatic developing machine, using a developer which contains at least one surfactant selected from the group consisting of anionic surfactants and nonionic surfactants in an amount of from 1% by mass to 10% by mass, and has a content of an organic solvent having a boiling point within a range of from 100°C to 300°C of 2% by mass or lower, but does not contain an organic solvent having a boiling point of lower than 100°C or a boiling point of higher than 300°C or, if contains, has a content thereof of 0.2% by mass or lower; a waste liquid concentrating step of evaporating and concentrating the platemaking waste liquid generated in the platemaking step, using a waste liquid concentration unit, such that the ratio of the volume of the platemaking waste liquid after the concentration to the volume of the platemaking waste liquid before the concentration is from 1/2 to 1/10; a reclaimed water producing step of taking out the steam that has been separated in the waste liquid concentrating step from the waste liquid concentration unit, and condensing the steam using a cooling means to produce reclaimed water; and a reclaimed water supplying step of supplying the reclaimed water obtained in the reclaimed water producing step to the automatic developing machine.
[10] The method of recycling a platemaking waste liquid according to [9], wherein the surfactant is an anionic surfactant.
[11] The method of recycling a platemaking waste liquid according to [10], wherein the anionic surfactant includes a sulfonic acid salt having a diphenyl ether skeleton.
[12] The method of recycling a platemaking waste liquid according to [11], wherein the developer contains two or more types of sulfonic acid salts having a diphenyl ether skeleton.
[13] The method of recycling a platemaking waste liquid according to any one of [9] to [12], wherein the organic solvent having a boiling point within a range of from 100°C to 300°C is ethylene glycol, and the content of ethylene glycol with respect to the developer is from 0.1 % by mass to 1.0% by mass.
[14] The method of recycling a platemaking waste liquid according to any one of [9] to [13], wherein the developer further contains a water-soluble resin.
[15] The method of recycling a platemaking waste liquid according to any one of [9] to [14], wherein the pH of the developer is from 6 to 10.
[16] The method of recycling a platemaking waste liquid according to any one of [9] to [15], including a planographic printing plate drying step of drying a planographic printing plate obtained through the platemaking step.
[17] The method of recycling a platemaking waste liquid according to any one of [9] to [16], wherein the waste liquid concentration unit has a heating means.
[18] The method of recycling a platemaking waste liquid according to [17], wherein heating is carried out under reduced pressure, using the heating means included in the waste liquid concentration unit.
[19] The method of recycling a platemaking waste liquid according to [17] or [18], wherein the heating means included in the waste liquid concentration unit is a heat pump including a heat radiating section and a heat absorbing section, and the platemaking waste liquid is heated at the heat radiating section of the heat pump, while the steam is cooled at the heat absorbing section of the heat pump.
[20] The method of recycling a platemaking waste liquid according to any one of [9] to [19], wherein the waste liquid concentrating step further includes a concentrate collecting step of collecting a concentrate of the platemaking waste liquid, which has been concentrated by evaporation concentration, into a recovery tank by applying pressure to the concentrate using a pump.

### Advantageous Effects of Invention

According to the invention, a method of concentrating a platemaking waste liquid may be provided, with which foaming at the time of concentrating the waste liquid generated in the platemaking process, in which development and desensitization are carried out in one step, using a developer in an automatic developing machine, is suppressed, concentration is efficiently carried out, and washing of the concentration pot or the like can be easily carried out.

That is, the amount of waste liquid can be reduced by performing development and desensitization in one step, using a developer in an automatic developing machine; and moreover, in the invention, by concentrating the platemaking waste liquid, the amount of waste liquid to be discarded can be reduced significantly. Furthermore, foaming at the time of concentrating the platemaking waste liquid is suppressed, and washing of the concentration unit can be carried out easily.

Further, according to the invention, a method of recycling a platemaking waste liquid may be provided, with which, by recycling the reclaimed water obtained when the platemaking waste liquid is concentrated, the amount of stains due to accumulation of deposits in the developing bath of the automatic developing machine is reduced and, even in a case in which platemaking process is carried out continuously for a long time, generation of precipitates is suppressed.

That is, with regard to the reclaimed water obtained by the method of concentrating a platemaking waste liquid according to the invention, there is no problem of the platemaking waste liquid being mixed into the reclaimed water, a large increase in the viscosity during the concentration, or precipitation of solids. Thus, by recycling the reclaimed water into the developing bath, the amount of waste liquid to be discarded as the platemaking waste liquid can be reduced, even in a case in which platemaking processing is carried out continuously for a long time.

### BRIEF DESCRIPTION OF DRAWINGS

Fig. 1 is a conceptual diagram showing a mode of the flow related to a method of processing a platemaking waste liquid, using a development processing apparatus according to the method of recycling a platemaking waste liquid of the invention.
Fig. 2 is a conceptual diagram showing a mode of the flow related to a method of processing a platemaking waste liquid, using a conventionally used development processing apparatus that includes a concentration unit for a waste liquid generated in development.
Fig. 3 is a schematic diagram showing a mode of the configuration of an automatic developing machine, which is equipped with a developer applying means that applies a developer to the plate surface, and which performs development and desensitization in one step, in the automatic developing machine.
Fig. 4 is a schematic diagram showing a mode of the configuration of an automatic developing machine including plural development sections that perform development and desensitization in one step, in the automatic developing machine.
Fig. 5 is a schematic diagram showing a mode of the configuration of an automatic developing machine, which is equipped with a developing bath, and which performs development and desensitization in one step, in the automatic developing machine.

### DESCRIPTION OF EMBODIMENTS

In the present specification, a numerical range expressed using "to" denotes a numerical range including numerical values described in front of and behind "to", as the minimum value and the maximum value, respectively.

In the specification, the term "step" includes not only an independent step, but also a case which cannot be clearly distinguished from other steps, as long as the predetermined purpose of the step is achieved.

In the specification, the term "development" means that the uncured region in an image recording layer is removed by development, and the term "platemaking" means that "desensitization" of an image area is performed, in addition to "development", to produce a planographic printing plate capable of being used for printing.

Hereinafter, the invention is explained in detail.

### [Method of Concentrating Platemaking Waste Liquid Generated in Processing Photosensitive Planographic Printing Plate Precursor]

The method of concentrating a platemaking waste liquid generated in processing a photosensitive planographic printing plate precursor according to the invention (hereinafter, may be referred to as "waste liquid concentrating method") includes: a platemaking step in which development and desensitization of a photosensitive planographic printing plate precursor, which has, on a support, a thermally fusible image recording layer that contains thermoplastic polymer particles and a photothermal conversion agent and which has undergone exposure, are conducted in one step in an automatic developing machine, using a developer described below; a waste liquid concentrating step of evaporating and concentrating a platemaking waste liquid generated in the platemaking step, using a waste liquid concentration unit, such that the ratio of the volume of the platemaking waste liquid after the concentration to the volume of the platemaking waste liquid before the concentration is from 1/2 to 1/10; and a reclaimed water producing step of taking out the steam that has been separated in the waste liquid concentrating step from the evaporation concentration unit, and condensing the steam using a cooling means to produce reclaimed water. The developer used in the platemaking step is a developer which contains at least one surfactant selected from the group consisting of anionic surfactants and nonionic surfactants in an amount of from 1% by mass to 10% by mass, and has a content of an organic solvent having a boiling point within a range of from 100°C to 300°C of 2% by mass or lower, but does not contain an organic solvent having a boiling point of lower than 100°C or a boiling point of higher than 300°C or, if contains, has a content thereof of 0.2% by mass or lower.

The photosensitive planographic printing plate precursor used in the invention has, on a support, an image recording layer that contains thermoplastic polymer particles and a photothermal conversion agent. The image recording layer of the photosensitive planographic printing plate precursor is exposed to light, to form a latent image, and thereafter, the non-image area is removed by platemaking process using the developer, to produce a planographic printing plate. The photosensitive planographic printing plate precursor used in the invention is a photosensitive planographic printing plate precursor having a negative type image recording layer. When the image recording layer is exposed to light, the thermoplastic polymer particles in the exposed region thermally fuse to each other to form an image area, and when the thermoplastic polymer particles, which have not fused, in the unexposed area (non-image area) are removed by development, an ink-receiving image area region and a non-image area region where a hydrophilic support is exposed are formed.

One of the characteristics of the waste liquid concentrating method and recycling method of the invention is that removal (development) of the non-image area and desensitization of the image area formed are conducted in one step in an automatic developing machine, and by this step, the amount of waste liquid is further reduced, as compared with conventional methods.

Hereinafter, the waste liquid concentrating method of the invention is explained in the order of operations. The photosensitive planographic printing plate precursor used and the exposing step that is performed prior to the platemaking step are described below.

### [Platemaking Step]

In the platemaking step, in an automatic developing machine that develops, after exposure, a photosensitive planographic printing plate precursor having a thermally fusible image recording layer on a support, development and desensitization are conducted with respect to the photosensitive planographic printing plate precursor that has undergone exposure, in one step, using a developer. The developer contains at least one surfactant selected from the group consisting of anionic surfactants and nonionic surfactants in an amount of from 1% by mass to 10% by mass, and has a content of an organic solvent having a boiling point within a range of from 100°C to 300°C of 2% by mass or lower, but does not contain an organic solvent having a boiling point of lower than 100°C or higher than 300°C or, if contains, has a content thereof of 0.2% by mass or lower.

### [Developer]

The developer that is used for developing a photosensitive planographic printing plate precursor, in the method of concentrating a platemaking waste liquid and recycling method of the invention, is explained.

In the present specification, unless otherwise specified, the term "developer" has a meaning that encompasses a development initiating liquid (a developer in a narrow sense) and a replenishment developer.

The developer and the replenishment developer, which are used in the invention, are developing liquids for developing a photosensitive planographic printing plate precursor having a thermally fusible image recording layer, and are developing liquids used for performing development and desensitization in one step, in an automatic developing machine.

The developer used in the invention is a developer that satisfies the following requirements (a), (b), and (c).
(a) Containing at least one surfactant selected from the group consisting of anionic surfactants and nonionic surfactants in an amount of from 1% by mass to 10% by mass.
(b) The content of an organic solvent having a boiling point within a range of from 100°C to 300°C is 2% by mass or lower.
   In the developer used in the invention, the content of the organic solvent having a boiling point within a range of from 100°C to 300°C is the lower, the better; and the case in which the organic solvent having a boiling point within a range of from 100°C to 300°C is not contained is also preferable.
(c) Neither an organic solvent having a boiling point of lower than 100°C nor an organic solvent having a boiling point of higher than 300°C is contained; or in a case in which any of them is contained, the total content thereof is 0.2% by mass or lower.

### [At Least One Surfactant Selected from the Group Consisting of Anionic Surfactants and Nonionic Surfactants]

The surfactant which is used in the developer in the waste liquid concentrating method of the invention is not particularly limited, as long as the surfactant is a surfactant selected from the group consisting of anionic surfactants and nonionic surfactants.

Hereinafter, the surfactant which can be used in the developer used in the invention is explained in detail.

### [Anionic Surfactant]

The anionic surfactant used in the invention is not particularly limited, and examples thereof include a fatty acid salt, an abietic acid salt, a hydroxyalkane sulfonic acid salt, an alkane sulfonic acid salt, a dialkylsulfosuccinic acid salt, a sulfonic acid salt having a diphenyl ether skeleton, a straight-chain alkylbenzenesulfonic acid salt, a branched alkylbenzenesulfonic acid salt, an alkylnaphthalenesulfonic acid salt, an alkylphenoxy polyoxyethylene propyl sulfonic acid salt, a polyoxyethylene alkyl sulfophenyl ether salt, an N-methyl-N-oleiltaurine sodium salt, a sulfosuccinic acid (N-alkyl)monoamide disodium salt, a petroleum sulfonic acid salt, sulfated castor oil, sulfated beef tallow oil, a sulfate ester salt of a fatty acid alkyl ester, an alkylsulfate ester salt, a polyoxyethylene alkyl ether sulfate ester salt, a fatty acid monoglyceride sulfate ester salt, a polyoxyethylene alkyl phenyl ether sulfate ester salt, a polyoxyethylene styryl phenyl ether sulfate ester salt, an alkylphosphate ester salt, a polyoxyethylene alkyl ether phosphate ester salt, a polyoxyethylene alkyl phenyl ether phosphate ester salt, a partially saponified product of a styrene-maleic anhydride copolymer, a partially saponified product of an olefin-maleic anhydride copolymer, and a naphthalene sulfonic acid salt formalin condensate.

Among them, a dialkylsulfosuccninc acid salt, a sulfonic acid salt having a diphenyl ether skeleton, an alkylsulfate ester salt, or an alkylnaphthalenesulfonic acid salt is particularly preferably used.

The anionic surfactant is most preferably a sulfonic acid salt which has a diphenyl ether skeleton and is represented by the following formula.

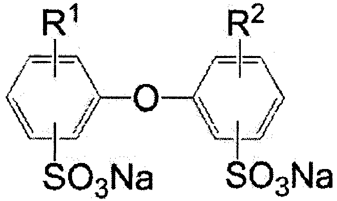

In the formula above, each of R¹ and R² independently represents a hydrogen atom or an alkyl group having from 1 to 20 carbon atoms. In a more preferable embodiment, R¹ represents an alkyl group having from 4 to 18 carbon atoms, and R² represents a hydrogen atom.

The developer used in the invention may contain two or more types of the anionic surfactants, which are sulfonic acid salts having a diphenyl ether skeleton, represented by the above formula. In the case of containing two or more types of sulfonic acid salts each having a diphenyl ether skeleton, a combination of a surfactant, in which R¹ represents an alkyl group having from 4 to 18 carbon atoms and R² represents a hydrogen atom in the above formula, and a surfactant, in which R¹ represents an alkyl group having from 4 to 18 carbon atoms and R² represents the same alkyl group as R¹ in the formula, is preferable.

A specific example of a best combination may be a combination of the following two anionic surfactants.

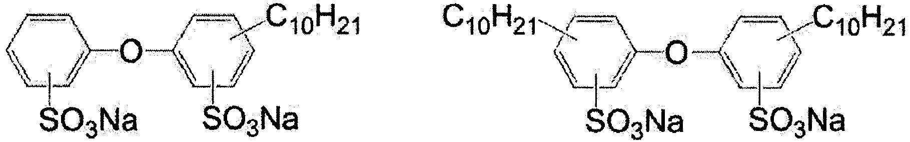

### [Nonionic Surfactant]

The nonionic surfactant used in the invention is not particularly limited, and examples thereof include a higher alcohol ethylene oxide adduct of polyethylene glycol type, an alkylphenol ethylene oxide adduct, a fatty acid ethylene oxide adduct, a polyhydric alcohol fatty acid ester ethylene oxide adduct, a higher alkylamine ethylene oxide adduct, a fatty acid amide ethylene oxide adduct, ethylene oxide adducts of fats and oils, a polypropylene glycol ethylene oxide adduct, a dimethylsiloxane-ethylene oxide block copolymer, a dimethylsiloxane-(propylene oxide-ethylene oxide) block copolymer and the like, a fatty acid ester of glycerol of polyhydric alcohol type, a fatty acid ester of pentaerythritol, fatty acid esters of sorbitol and sorbitan, a fatty acid ester of sucrose, an alkyl ether of polyhydric alcohol, and a fatty acid amide of an alkanolamine. Note that, the higher alkyl in the higher alcohol or the higher alkylamine indicates an alkyl having from 9 to 30 carbon atoms.

As the nonionic surfactant in the invention, an ethylene oxide adduct of sorbitol and/or sorbitan fatty acid ester, a polypropylene glycol ethylene oxide adduct, a dimethylsiloxane-ethylene oxide block copolymer, a dimethylsiloxane-(propylene oxide-ethylene oxide) block copolymer, and a fatty acid ester of a polyhydric alcohol are more preferable.

Further, from the viewpoints of stable solubility in water and turbidity, the nonionic surfactant which is used in the developer used in the invention is preferably a nonionic surfactant having an HLB (Hydrophile-Lipophile Balance) value of 6 or more, and more preferably a nonionic surfactant having an HLB value of 8 or more.

These nonionic surfactants may be used singly, or in combination of two or more kinds thereof.

The surfactants which are incorporated in the developer used in the invention may be used singly, or in combination of plural kinds thereof. In the case of using two or more kinds of surfactants in combination, any of a mode in which two or more kinds of anionic surfactants are used, a mode in which two or more kinds of nonionic surfactants are used, or a mode, in which one or more kinds of anionic surfactants and one or more kinds of nonionic surfactants are used, may be employed.

Above all, a mode in which two or more types of sulfonic acid salts each having a diphenyl ether skeleton, which are anionic surfactants, are used is preferable.

The content of the surfactant in the developer is required to be in a range of from 1% by mass to 10% by mass, and is preferably in a range of from 2% by mass to 10% by mass, and is more preferably in a range of from 3% by mass to 10% by mass, from the viewpoint of the effects. When the content of the surfactant in the developer is 1% by mass or higher, the developing property and the solubility of the components of the image recording layer in the developer are favorable, and when the content is 10% by mass or lower, the printing durability of the planographic printing plate formed is favorable.

Note that, in a case in which two or more kinds of particular surfactants are used, the above content represents the total content of the particular surfactants.

### [Organic Solvent]

In the invention, the developer and the replenishment developer, which are used for developing a photosensitive planographic printing plate precursor, may contain an organic solvent having a boiling point within a range of from 100°C to 300°C, for the purpose of enhancing the solubility of the components of the image recording layer or the like. However, the content thereof should be in a range of 2% by mass or lower, and the case in which an organic solvent having a boiling point within a range of from 100°C to 300°C is not contained is also preferable.

Regarding the kind of the organic solvent having a boiling point within a range of from 100°C to 300°C, which can be used in the developer, any organic solvent may be used as long as the boiling point is within the range of from 100°C to 300°C. Preferable examples include 2-phenylethanol (boiling point: 219°C), 3-phenyl-1-propanol (boiling point: 238°C), 2-phenoxyethanol (boiling point: from 244°C to 255°C), benzyl alcohol (boiling point: 205°C), cyclohexanol (boiling point: 161°C), monoethanolamine (boiling point: 170°C), diethanolamine (boiling point: 268°C), cyclohexanone (boiling point: 155°C), ethyl lactate (boiling point: 155°C), propylene glycol (boiling point: 187°C), ethylene glycol (boiling point: 198°C), γ-butyrolactone (boiling point: 205°C), N-methylpyrrolidone (boiling point: 202°C), N-ethylpyrrolidone (boiling point: 218°C), glycerin (boiling point: 290°C), propylene glycol monomethyl ether (boiling point: 120°C), ethylene glycol monomethyl ether (boiling point: 124°C), ethylene glycol monomethyl ether acetate (boiling point: 145°C), diethylene glycol dimethyl ether (boiling point: 162°C), and ethylene glycol (boiling point: 197°C). Among them, benzyl alcohol, diethanolamine, monoethanolamine, γ-butyrolactone, N-methylpyrrolidone, N-ethylpyrrolidone, and ethylene glycol are particularly preferable.

In the developer, the content of the organic solvent having a boiling point within a range of from 100°C to 300°C is preferably in a range of from 0.1% by mass to 1.0% by mass.

In a case in which the developer used in the invention contains two or more kinds of organic solvents having a boiling point within a range of from 100°C to 300°C, the above content represents the total content of the organic solvent incorporated in the developer.

When the boiling point of the organic solvent incorporated in the developer is lower than 100°C, the organic solvent evaporates easily, and when the boiling point is higher than 300°C, it is more difficult to perform concentration, which is thus not preferable.

Accordingly, an organic solvent other than the above, namely, an organic solvent having a boiling point of lower than 100°C or a boiling point of higher than 300°C is not incorporated in the developer, or in the case of being incorporated, the content thereof should be 0.2% by mass or lower with respect to the developer. That is, when the content of the above organic solvent in the developer is determined by gas chromatography, the content is required to be 0.2% by mass or lower.

Regarding the developer in the exemplary embodiment of the invention, it is more preferable that the developer used in the invention does not substantially contain either an organic solvent having a boiling point of lower than 100°C or an organic solvent having a boiling point of higher than 300°C. The expression "does not substantially contain" means that the organic solvent is not contained at all, or even if contained, the organic solvent is contained only as an inevitable impurity.

The developer used in the invention is an alkali developer that contains the surfactant described above and the alkali agent described below.

### [pH]

In the invention, in the platemaking step, development and desensitization are conducted in one step, using a developer, and therefore, the pH of the developer used herein is preferably from 6.0 to 11.0, and more preferably from 6.5 to 9.5, from the viewpoint of the effects.

Further, in the developer used in the invention, other than the alkali agent described below and the surfactant described above, various known additives may be used in combination, as long as the effects of the invention are not impaired.

### [Organic Acid or Salt Thereof]

The pH of the developer may be adjusted using a pH adjusting agent.

It is preferable that the developer contains, as the pH adjusting agent, an organic carboxylic acid such as citric acid, malic acid, tartaric acid, gluconic acid, benzoic acid, phthalic acid, p-ethylbenzoic acid, p-n-propylbenzoic acid, p-isopropylbenzoic acid, p-n-butylbenzoic acid, p-t-butylbenzoic acid, p-2-hydroxyethyl benzoic acid, decanoic acid, salicylic acid, or 3-hydroxy-2-naphthoic acid, or a metal salt thereof, an ammonium salt thereof, or the like.

Citric acid has a function as a buffer, and citric acid is added as, for example, trisodium citrate or tripotassium citrate.

In the developer used in the invention, one kind or two or more kinds of pH adjusting agents can be used.

The content of the pH adjusting agent in the developer according to the invention is generally in a range of from 0.05% by mass to 5% by mass, and preferably in a range of from 0.3% by mass to 3% by mass.

In a case in which the developer used in the invention contains two or more kinds of pH adjusting agents, the above content represents the total amount of the pH adjusting agents.

### [Water-Soluble Resin]

A water-soluble resin may added to the developer used in the invention, in order to reinforce the function of protecting plate surfaces as a gum liquid in desensitization that is carried out together with development in one step in the developing bath.

Examples of the water-soluble resin, which can be added to the developer used in the invention, include soybean polysaccharides, modified starches, gum arabic, dextrin, cellulose derivatives (for example, carboxymethyl cellulose, carboxyethyl cellulose, methyl cellulose, or the like) and modified products thereof, pullulan, polyvinyl alcohol and derivatives thereof, polyvinyl pyrrolidone, polyacrylamide and acrylamide copolymers, a vinyl methyl ether/ maleic anhydride copolymer, a vinyl acetate/ maleic anhydride copolymer, and a styrene/ maleic anhydride copolymer. The acid value of the water-soluble resin is preferably from 0 meq/g to 3.0 meq/g.

Regarding the soybean polysaccharides, conventionally known soybean polysaccharides can be used, and an example of a commercially available product is SOYAFIVE (trade name, manufactured by Fuji Oil Co., Ltd.), and products of various grades can be used. A soybean polysaccharide in which the viscosity of a 10% by mass aqueous solution thereof is in a range of from 1 Pa/sec to 100 mPa/sec is preferably used.

Regarding the modified starches, a modified starch represented by the following Formula (VII) is preferable. Examples of the modified starch represented by Formula (VII) include those obtained by modifying starches obtained from any of corn, potato, tapioca, rice, wheat, or the like. Any of the above examples may be used in the invention.

Modification of starches can be carried out by a method of decomposing starch using an acid, an enzyme, or the like, such that the number of glucose residues per one molecule is within the range of from 5 to 30, and further adding oxypropylene in an alkali, or the like.

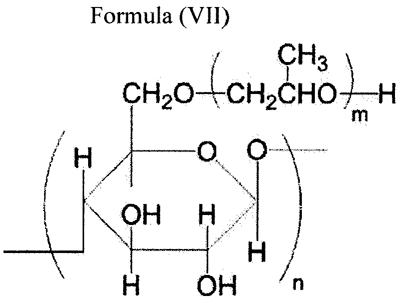

In Formula (VII), n represents an integer from 3 to 30, and m represents an integer from 1 to 3.

The degree of etherification (degree of substitution) of the compound represented by Formula (VII) is in a range of from 0.05 to 1.2 per glucose unit.

Among the water-soluble resins, soybean polysaccharides, modified starches described above, gum arabic, dextrin, carboxymethyl cellulose, polyvinyl alcohol, and the like are particularly preferable. Above all, the water-soluble resin is most preferably dextrin.

The water-soluble resins can be used in combination of two or more kinds thereof.

The content of the water-soluble resin in the developer is preferably from 0.1% by mass to 20% by mass, more preferably from 0.5% by mass to 10% by mass, and particularly preferably from 1.0% by mass to 5.0% by mass.

In a case in which the developer used in the invention contains two or more kinds of water-soluble resins, the above content represents the total amount of the water-soluble resins incorporated in the developer.

### [Chelating Agent]

The developer may contain a chelating agent for a divalent metal. Examples of the divalent metal include magnesium and potassium.

Examples of the chelating agent include polyphosphoric acid salts such as Na₂P₂O₇, Na₅P₃O₃, Na₃P₃O₉, Na₂O₄P(NaO₃P)PO₃Na₂, or CALGON (trade name; sodium polymetaphosphate), and amino polycarboxylic acids selected from ethylenediaminetetraacetic acid, a potassium salt thereof, and a sodium salt thereof; diethylenetriaminepentaacetic acid, a potassium salt thereof, and a sodium salt thereof; triethylenetetraminehexaacetic acid, a potassium salt thereof, and a sodium salt thereof; hydroxyethyl ethylenediaminetriacetic acid, a potassium salt thereof, and a sodium salt thereof; nitrilotriacetic acid, a potassium salt thereof, and a sodium salt thereof; 1,2-diaminocyclohexanetetraacetic acid, a potassium salt thereof, and a sodium salt thereof; 1,3-diamino-2-propanoltetraacetic acid, a potassium salt thereof, and a sodium salt thereof; and the like.

Other examples of the chelating agent, which can be used in the invention, may include organic phosphonic acids such as 2-phosphonobutanetricarboxylic acid-1,2,4, a potassium salt thereof, or a sodium salt thereof; 2-phosphonobutanonetricarboxylic acid-2,3,4, a potassium salt thereof, or a sodium salt thereof; 1-phosphonoethanetricarboxylic acid-1,2,2, a potassium salt thereof, or a sodium salt thereof; 1-hydroxyethane-1,1-diphosphonic acid, a potassium salt thereof, or a sodium salt thereof; or aminotri(methylenephophonic acid), a potassium salt thereof, or a sodium salt thereof, and biodegradable chelating agents such as (S,S)-ethylenediaminedisuccinic acid (EDDS), (S,S)-ethylenediaminedisuccinic acid trisodium salt (EDDS-Na₃), or tetrasodium glutamate diacetate.

The content of such a chelating agent in the developer may vary according to the hardness and the amount of use of the hard water used in the developer; however, the content of the chelating agent in the developer is generally in a range of from 0.01% by mass to 5% by mass, and more preferably in a range of from 0.01% by mass to 0.5% by mass.

In a case in which the developer used in the invention contains two or more kinds of chelating agents, the above content represents the total amount of the chelating agents incorporated in the developer.

### [Antifoaming Agent]

When an anionic surfactant is incorporated in the developer, there is a concern that foam is easily formed. Therefore, in a case in which an anionic surfactant is incorporated in the developer, an antifoaming agent may be added.

In the case of adding an antifoaming agent in the developer, the content of the antifoaming agent with respect to the developer is preferably 0.00001% by mass or higher, and more preferably in a range of from about 0.0001% by mass to about 0.5% by mass.

Examples of the antifoaming agent, which can be used in the developer used in the invention, include a fluorine-containing antifoaming agent, a silicone antifoaming agent, acetylene alcohol, and acetylene glycol.

Hereinafter, the antifoaming agent, which can be used in the developer in the invention, is explained in detail.

Examples of the fluorine-containing antifoaming agent include compounds represented by the formula described below.

Above all, a fluorine-containing antifoaming agent having an HLB value of from 1 to 9 is preferably used, and a fluorine-containing antifoaming agent having an HLB value of from 1 to 4 is particularly preferably used. The above fluorine-containing antifoaming agent may be added as it is to the developer, or may be added to the developer in the form of an emulsion obtained by mixing with water, a solvent other than water, or the like.

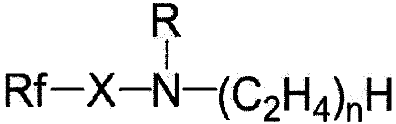

In the formula above, R represents a hydrogen atom or an alkyl group, Rf represents a fluorinated alkyl group (having from about 5 to about 10 carbon atoms) in which some or all of the hydrogen atoms in the alkyl group are replaced by fluorine atoms. X represents C(O) or SO₂, and n represents an integer from 1 to 10.

An example of the silicone antifoaming agent is dialkyl polysiloxane, and dialkyl polysiloxane having a structure shown below is preferable. The silicone antifoaming agent may be added as it is to the developer, or may be added to the developer in the form of an O/W type emulsion prepared by using water, a solvent other than water, or the like.

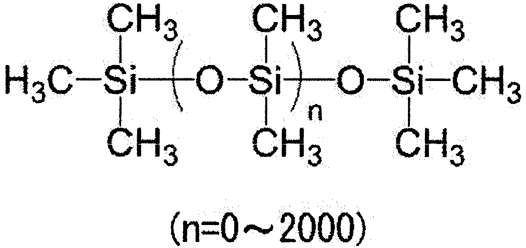

Other examples of the silicone antifoaming agent include alkoxypoly(ethyleneoxy) siloxane having a structure shown below and an acid-modified siloxane compound that is obtained by partially introducing carboxyl groups or sulfonic acid groups into dimethyl polysiloxane to perform modification. The modified siloxane compound that serves as the antifoaming agent may be added as it is to the developer, or may be added to the developer as a modified siloxane compound-containing O/W type emulsion prepared by using water, a solvent other than water, or a generally known anionic surfactant. 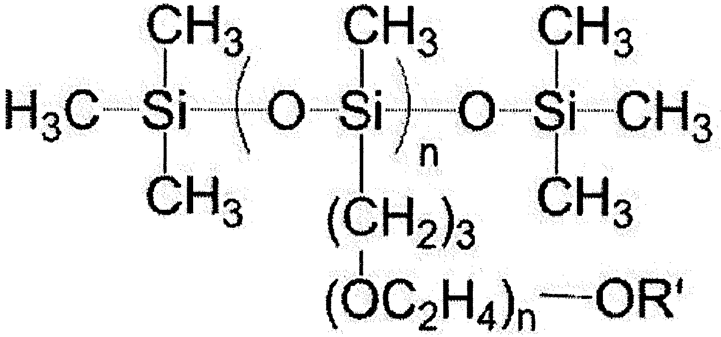 (n: 6 to 10, R': an alkyl group having from 1 to 4 carbon atoms) 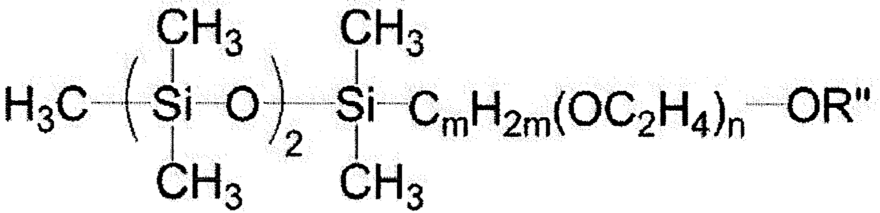 (m: 2 to 4, n: 4 to 12, R": an alkyl group having from 1 to 4 carbon atoms)

Acetylene alcohol, which serves as an antifoaming agent usable in the developer in the invention, is an unsaturated alcohol having an acetylene bond (triple bond) in a molecule thereof. Further, acetylene glycol is also called "alkynediol" and is an unsaturated glycol having an acetylene bond (triple bond) in a molecule thereof.

Examples of an antifoaming agent selected from acetylene alcohol and acetylene glycol, which can be used in the developer in the invention, include, more specifically, compounds represented by the following Formula (1) or Formula (2).

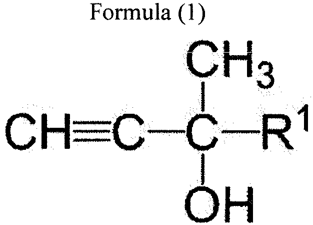

In Formula (1), R¹ represents a straight chain or branched alkyl group having from 1 to 5 carbon atoms.

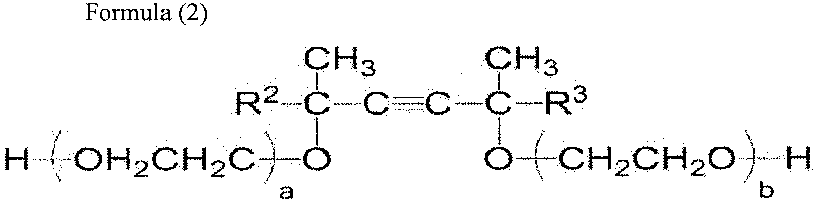

In Formula (2), each of R² and R³ independently represents a straight chain or branched alkyl group having from 1 to 5 carbon atoms, and a + b is a number of from 1 to 30. However, a and b never represent 0 at the same time.

In Formula (2), examples of the straight chain or branched alkyl group having from 1 to 5 carbon atoms include a methyl group, an ethyl group, an isopropyl group, an isobutyl group, and an isopentyl group.

More specific examples of the acetylene alcohol and the acetylene glycol include the following compounds.
(1) Propargyl alcohol
(2) Propargyl carbinol
(3) 3,5-Dimethyl-1-hexyn-3-ol
(4) 3-Methyl-1-butyn-3-ol
(5) 3-Methyl-1-pentyn-3-ol
(6) 1,4-Butynediol
(7) 2,5-Dimethyl-3-hexyne-2,5-diol
(8) 3,6-Dimethyl-4-octyne-3,6-diol
(9) 2,4,7,9-Tetramethyl-5-decyne-4,7-diol
(10) Ethylene oxide adduct of 2,4,7,9-tetramethyl-5-decyne-4,7-diol (the structure shown below) 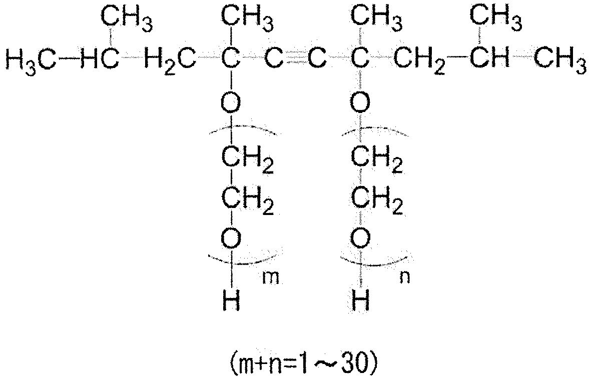
(11) 2,5,8,11-tetramethyl-6-dodecyne-5,8-diol

These acetylene alcohols and acetylene glycols are available from the market. As commercially available products of acetylene alcohol or acetylene glycol, for example, products under the trade name SURFYNOL, manufactured by Air Products and Chemicals Inc. are known. Specific examples of the commercially available products include SURFYNOL 61 (trade name) as the (3) 3,5-dimethyl-1-hexyn-3-ol; OLFINE B (trade name) as the (4) 3-methyl-1-butyn-3-ol; OLFINE P (trade name) as the (5) 3-methyl-1-pentyn-3-ol; OLFINE Y (trade name) as the (7) 2,5-dimethyl-3-hexyne-2,5-diol; SURFYNOL 82 (trade name) as the (8) 3.6-dimethyl-4-octyne-3,6-diol; SURFYNOL 104 and OLFINE AK-02 (all trade names) as the (9) 2,4,7,9-tetramethyl-5-decyne-4,7-diol; SURFYNOL 400 (trade name) series as the (10) ethylene oxide adduct of 2,4,7,9-tetramethyl-5-decyne-4,7-diol; and SURFYNOL DF-110D as the (11) 2,5,8,11-tetramethyl-6-dodecyne-5,8-diol; and the like.

### [Additional Additives]

A development adjusting agent selected from the group consisting of an alkali metal salt of an organic acid and an alkali metal salt of an inorganic acid may be added to the developer. Examples of the development adjusting agent include sodium carbonate, potassium carbonate, ammonium carbonate, sodium citrate, potassium citrate, and ammonium citrate. The development adjusting agents may be used singly or in combination of two or more kinds thereof.

Further, an alkali agent may be added to the developer. Examples of the alkali agent include an inorganic alkali agent selected from sodium tertiary phosphate, potassium tertiary phosphate, ammonium tertiary phosphate, sodium borate, potassium borate, ammonium borate, sodium hydroxide, potassium hydroxide, ammonium hydroxide, lithium hydroxide, or the like; and an organic alkali agent selected from monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine, pyridine, tetramethylammonium hydroxide, or the like. These alkali agents may be used singly, or in combination of two or more kinds thereof.

The developer may contain, other than the above components, various components described below, as necessary. Examples of the components, which may be incorporated in the developer as needs arise, include a reducing agent, a dye, a pigment, a water softener, and an antiseptic.

### (Water)

The remainder component of the developer described above is water. It is advantageous in view of transportation that the developer (developer stock liquid) used in the invention is prepared as a concentrated liquid having a lower content of water than that at the time of use, and is diluted with water at the time of use. The concentration degree of the concentrated liquid of the developer (developer stock liquid) is preferably such a concentration degree that the respective components incorporated in the developer do not cause separation, precipitation, or the like. The reclaimed water described below may be used as the water.

In the above platemaking step, development and desensitization can be favorably performed in one step, by using the developer described above (hereinafter, may be referred to as "specific developer"). "Performing development and desensitization in one step" indicates that development and desensitization are performed in a single processing section (in a single processing tank), by using one kind of the specific developer described above, and in this case, it is not necessary to perform desensitization in other processing section which is generally performed successively after development.

In the invention, the development and desensitization process may be repeatedly performed two or more times, as far as development and desensitization are performed in one step. Namely, by using an automatic developing machine having only one development section, an automatic developing machine having two or more development sections that are adjacent to each other, an automatic developing machine having a development section and a desensitization section (gumming section) that are adjacent to each other, or the like, the platemaking step may be carried out two or more times in two or more processing sections, while supplying the developer used in the invention to each processing sections.

When repeatedly performing the platemaking processing used in the invention, in which development and desensitization are carried out in one step, using a specific developer, a developer containing a little amount of impurities, such as development scum, contacts the plate in the development section at the downstream side and thus, there is an advantage that the image quality of the image formed is further enhanced.

The platemaking process in the invention is carried out at a temperature of from 0°C to 60°C, and preferably from about 15°C to about 40°C. The platemaking step can be carried out by a conventional method, for example, by a method of immersing a photosensitive planographic printing plate precursor that has been imagewise exposed in a specific developer, and scrubbing the printing plate precursor with a brush; a method of spraying a specific developer onto the plate surface of a planographic printing plate precursor by spraying or the like, and scrubbing the printing plate precursor with a brush; or the like.

The platemaking step in the invention can be suitably carried out by using an automatic developing machine equipped with a developer supplying means and a scrubbing member. An automatic developing machine using a rotating brush roll as the scrubbing member is particularly preferable.

It is preferable that two or more rotating brush rolls are used. Further, it is preferable that the automatic developing machine includes a means for removing the excess developer, such as a squeeze roller, a drying means such as a hot air device, or the like, after the development processing means. Furthermore, the automatic developing machine may include a pre-heating means for heat treating the photosensitive planographic printing plate precursor that has been imagewise exposed, before the development processing means.

When platemaking process is performed by using such an automatic developing machine, which further includes an additional means such as a scrubbing member or a means for removing the excess developer, there is an advantage that adhesion of development scum, which is generated during development and is derived from the constituent components of the protective layer and the image recording layer, to the plate surface of the planographic printing plate obtained by the platemaking process can be effectively suppressed.

### [Waste Liquid Concentrating Step]

In this step, the platemaking waste liquid generated in the platemaking step described above is evaporated and concentrated using a waste liquid concentration unit, such that the ratio of the volume of the platemaking waste liquid after the concentration to the volume of the platemaking waste liquid before the concentration is from 1/2 to 1/10.

Hereinafter, the waste liquid concentrating step in the invention is explained.

An example of the waste liquid concentration unit used in the waste liquid concentrating step in the invention is an evaporation concentration unit that includes at least an evaporation pot (not shown in the figure) that heats waste liquid without performing pressure reduction or under reduced pressure, and separates the waste liquid into moisture that evaporates and a concentrate (slurry) that remain; and a cooling pot (not shown in the figure) that cools and condenses the steam which has been separated in the evaporation pot and has taken out from the evaporation concentration unit and which may contain an organic solvent, to produce reclaimed water.

It is preferable that concentration of the waste liquid is carried out by a method of reducing the pressure inside of the evaporation pot described above, using a pressure reducing means, and heating and concentrating the waste liquid, since the boiling point of the waste liquid can be lowered and the waste liquid can be evaporated and concentrated at a temperature lower than that under atmospheric pressure. When a pressure reducing means is used, there are advantages that evaporation and concentration can be carried out at a lower temperature, the evaporation pot is less likely to be used at a high temperature, and the waste liquid and waste concentrate are less likely to be affected by the influence of heat.

Examples of the pressure reducing means used at the time of concentration of the waste liquid include a general mechanical vacuum pump of a type selected from a water seal type, an oil rotation type, a diaphragm type, or the like; a diffusion pump using oil or mercury; a compressor such as a multi-stage turbo compressor, a reciprocating compressor, or a screw compressor; and an aspirator. Among these pressure reducing means, an aspirator is preferable from the viewpoints of maintenance property and cost.

Regarding the conditions for pressure reduction, for example, the condition that reduces pressure to a value of from 666.6 Pa (5 mmHg) to 13332.2 Pa (100 mmHg) is preferable, and the condition that reduces pressure to a value of from 666.6 Pa (5 mmHg) to 3999.7 Pa (30 mmHg) is more preferable.

Regarding the heating condition, a temperature region corresponding to 666.6 Pa to 13332.2 Pa, which is a pressure that can be easily obtained by using a tap aspirator, a vacuum pump, or the like, is selected. Specifically, the temperature is in a range of from 20°C to 80°C, and preferably in a range of from 25°C to 45°C.

When distillation and concentration are performed at a high temperature, a large amount of electric power is needed; however, when concentration is performed under reduced pressure, the heating temperature can be further lowered as compared with the case of performing concentration under atmospheric pressure and, as a result, the amount of electric power used can be suppressed.

Further, it is also preferable to use a heat pump as the heating means in the evaporation pot, and it is preferable that the heat pump is equipped with a heat radiating section and a heat absorbing section. The platemaking waste liquid is heated at the heat radiating section of the heat pump, while the steam separated from the platemaking waste liquid can be cooled at the heat absorbing section of the heat pump. Thus, heating and concentration of the waste liquid are carried out by heat generation of the heat pump, and condensation of the steam is carried out by heat absorption of the heat pump. Therefore, the heat efficiency is favorable and, as compared with the case of using a heating means such as an electric heater, there are advantages that high temperature sites do not occur locally, the discharge amount of carbon dioxide is reduced, and the like.

In this step, when evaporation and concentration of the platemaking waste liquid are conducted in the waste liquid concentration unit, the platemaking waste liquid is evaporated and concentrated by heating using a heating means in the evaporation pot, such that the amount on the basis of volume becomes from 1/2 to 1/10 (=the amount of platemaking waste liquid after concentration/the amount of platemaking waste liquid before concentration: hereinafter, may also be referred to as "concentration rate"). Here, when the concentration ratio of the platemaking waste liquid is larger than 1/2, reduction of the amount of waste liquid that should be processed is not effectively conducted. In a case in which concentration is performed such that the concentration ratio is less than 1/10, precipitation of solid matters originated in the concentrated waste liquid is likely to occur in the evaporation pot of the waste liquid concentration unit 30, and there is a concern that maintenance property may be deteriorated. It is preferable that the platemaking waste liquid is concentrated such that the amount on the basis of volume becomes in a range of from 1/3 to 1/8. When concentration of the platemaking waste liquid is carried out within the above range of concentration, the amount of stains in the concentration pot is small, and continuous operation of the waste liquid concentration unit is enabled over a long term. Further, it is possible to reutilize the obtained reclaimed water, and the amount of waste liquid to be discarded as the platemaking waste liquid is extremely small.

In the present exemplary embodiment, examples of the waste liquid concentration unit used in the waste liquid concentrating step include commercially available products such as heat pump type concentrating apparatuses XR-2000 and XR-5000 (all trade names) manufactured by Takagi Refrigerating Co., Ltd. and heating type FRIENDLY series (trade name) manufactured by Cosmotech Co., Ltd.

The concentrate of the platemaking waste liquid may be pressurized using a pump and may be collected in a recovery tank (concentrate collecting step). By concentrating the platemaking waste liquid to produce a concentrate, the disposal volume of the platemaking waste liquid can be reduced.

### [Reclaimed Water Producing Step]

In this step, the steam separated in the waste liquid concentrating step is taken out from the waste liquid concentration unit, and is condensed (coagulated) to produce reclaimed water.

As described above, in a case in which heating and concentration of the waste liquid are carried out using a heat pump in the waste liquid concentrating step, the steam that is cooled at the heat absorbing section of the heat pump turns into a liquid state and, as a result, reclaimed water is obtained. Namely, in the waste liquid concentrating step, in the evaporation concentration unit equipped with a waste liquid heating means (or a heat radiating section) and a cooling means (a cooling pot or a heat absorbing section), reclaimed water is produced inside the evaporation concentration unit, and the reclaimed water thus produced is taken out from the evaporation concentration unit. This exemplary embodiment is also included in the reclaimed water producing step in the invention.

Further, in a case in which heating and concentration of the waste liquid are carried out by using a heating concentration unit equipped with a known heating means (an evaporation pot), such as an electric heater, and a cooling means (a cooling pot), the steam that has been separated by the heating means is conveyed to the cooling pot (cooling means) inside the waste liquid concentration unit, and the steam is condensed using the cooling means, to produce reclaimed water. Regarding the cooling means, a known water cooling cooler or the like may be used as appropriate.

The reclaimed water obtained as described above is reclaimed water having a low BOD value (Biochemical Oxygen Demand) and a low COD value (Chemical Oxygen Demand). In the case of using the developer used in the invention, the BOD value is about 250 mg/L or less, and the COD value is about 200 mg/L or less, and thus, the excess reclaimed water may be discharged directly into common drainage. However, in a case in which the reclaimed water contains an organic solvent or the like, the reclaimed water is subjected to a treatment using activated sludge or the like, before being discharged, and after removing the organic solvent or the like, the resulting reclaimed water can be discharged as an ordinary waste water.

Furthermore, as in the recycling method of the invention, which is described below, it is also preferable to reutilize the reclaimed water by supplying the reclaimed water to the developing bath as dilution water or the like.

### [Method of Recycling Platemaking Waste Liquid Generated in Processing Photosensitive Planographic Printing Plate Precursor]

The recycling method of the invention includes: a platemaking step in which development and desensitization of a photosensitive planographic printing plate precursor, which has, on a support, an image recording layer that contains thermoplastic polymer particles and a photothermal conversion agent and which has undergone exposure with an infrared laser, are conducted in one step in an automatic developing machine, using a developer described below; a waste liquid concentrating step of evaporating and concentrating a platemaking waste liquid generated in the platemaking step, using a waste liquid concentration unit, such that the ratio of the volume of the platemaking waste liquid after the concentration to the volume of the platemaking waste liquid before the concentration is from 1/2 to 1/10; a reclaimed water producing step of taking out the steam that has been separated in the waste liquid concentrating step from the evaporation concentration unit, and condensing the steam using a cooling means, to produce reclaimed water; and a reclaimed water supplying step of supplying the reclaimed water obtained in the reclaimed water producing step to the automatic developing machine. The developer used in the platemaking step is a developer which contains at least one surfactant selected from the group consisting of anionic surfactants and nonionic surfactants in an amount of from 1% by mass to 10% by mass, and has a content of an organic solvent having a boiling point within a range of from 100°C to 300°C of 2% by mass or lower, but does not contain an organic solvent having a boiling point of lower than 100°C or a boiling point of higher than 300°C or, if contains, has a content thereof of 0.2% by mass or lower.

That is, the recycling method of the invention further includes a reclaimed water supplying step, in addition to the platemaking step, the waste liquid concentrating step, and the reclaimed water producing step in the above-described method of concentrating a platemaking waste liquid of the invention.

In the recycling method of the invention, first, the produced reclaimed water is supplied to a replenishment water tank or the like, and may be used as a dilution water that dilutes the replenishment developer at a predetermined magnification in the developing bath which is disposed inside the automatic developing machine, or may be used as a rinse water used in the rinsing step after the platemaking process. Alternatively, the produced reclaimed water is directly supplied to the replenishment developer, and may be used as a dilution water for diluting the replenishment developer at a predetermined magnification.

Further, reclaimed water produced from the platemaking waste liquids generated from plural automatic developing machines may be collected in one replenishment water tank and used. Moreover, the reclaimed water thus produced may be supplied from one replenishment water tank to plural automatic developing machines as dilution water or rinse water.

Specific examples of the device which can be suitably used in the waste liquid concentrating method and recycling method of the invention include a planographic printing plate platemaking waste liquid reducing device described in Japanese Patent No. 4774124, and a waste liquid processing device described in JP-ANo. 2011-90282.

Hereinafter, an example of the exemplary embodiments in the invention is explained with reference to the drawings.

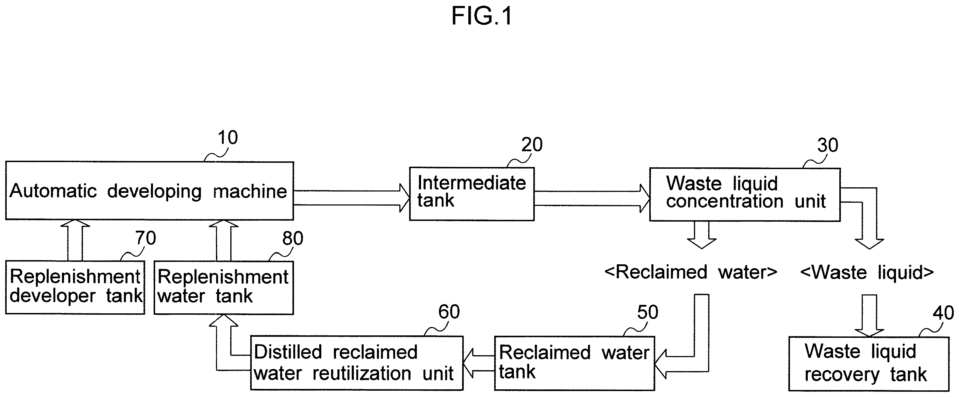

As shown in Fig. 1, in the method of recycling a platemaking waste liquid according to the present exemplary embodiment, an automatic developing machine 10; an intermediate tank 20 that stores the waste developer discharged from the automatic developing machine 10, accompanying the platemaking process of a photosensitive planographic printing plate precursor; and a waste liquid concentration unit 30 that heats the waste liquid delivered from the intermediate tank 20, without performing pressure reduction or under reduced pressure, and separates the waste liquid into moisture that evaporates and a concentrate (slurry) that remains, and further, cools and coagulates (condenses) the steam which has been separated, to produce reclaimed water, are used. Production of reclaimed water may be conducted inside the waste liquid concentration unit, or the steam may be taken out to another cooling means so that production of reclaimed water may be conducted by using a cooling means that is provided outside the waste liquid concentration unit.

The reclaimed water is introduced into a reclaimed water tank 50. Further, the waste liquid that has been concentrated in the waste liquid concentration unit 30 is collected in a waste liquid recovery tank 40. It is also preferable that transport of the concentrated waste liquid to the waste liquid recovery tank 40 is carried out by applying pressure using a pump.

The waste liquid concentration unit 30 is equipped with at least an evaporation pot (not shown in the figure) that heats the waste liquid delivered from the intermediate tank 20, without performing pressure reduction or under reduced pressure, and separates the waste liquid into moisture that evaporates and a concentrate (slurry) that remains; and a cooling pot (not shown in the figure) that takes out, cools, and condenses the steam that has been separated in the evaporation pot, thereby producing reclaimed water. The steam that has been separated in the evaporation pot may contain an organic solvent.

In the present exemplary embodiment, this system includes a reclaimed water tank 50 that temporarily stores the reclaimed water produced from the separated steam, and a distilled reclaimed water reutilization unit 60 that controls the supply of the reclaimed water to the automatic developing machine 10. The distilled reclaimed water reutilization unit 60 preferably includes a replenishment water tank 80 that supplies the reclaimed water to the automatic developing machine 10, a piping, and a pressure gauge that measures the pressure inside the piping, and a pump.

Further, the replenishment water tank 80 may include an analyzer. By using the analyzer placed at the replenishment water tank 80, the components of the reclaimed water are analyzed, and it is possible to judge whether the reclaimed water can be used as it is or not. The replenishment water tank 80 may further have a means that performs neutralization, supply of fresh water, or the like, with respect to the reclaimed water whose components have been analyzed, according to the components, thereby regulating the composition of the reclaimed water.

The recovered reclaimed water is reclaimed water having a low BOD value and a low COD value, as described below. Therefore, by controlling the drive of the pump according to the value of pressure measured using the pressure gauge equipped in the distilled reclaimed water reutilizing unit 60, the recovered reclaimed water is supplied from the replenishment water tank 80 to the automatic developing machine 10. To the automatic developing machine 10, a replenishment developer is supplied from a replenishment developer tank 70. Note that, in a case in which the reclaimed water is judged by analysis such that the composition needs to be regulated, the composition of the reclaimed water is regulated to a composition appropriate to be used, as necessary, and then the resulting reclaimed water is supplied to the automatic developing machine 10.

The reclaimed water obtained by this system may contain an organic solvent as far as the amount of the organic solvent is 0.5% or less on the basis of volume.

The reclaimed water thus obtained is reclaimed water having a low BOD value and a low COD value. In a case of in which the developer used in the invention is used, the BOD value is about 250 mg/L or less, and the COD value is about 200 mg/L or less, and therefore, besides being used as dilution water for evaporation correction in the automatic developing machine, dilution water for a replenishment developer, rinse water for washing the planographic printing plate after development, or wash water of the automatic developing machine, the excess reclaimed water may be discharged directly into common drainage.

In the invention, the replenishment developer is diluted and supplied to the developing bath of the automatic developing machine 10. Fig. 1 shows a mode in which the amount of the reclaimed water to be supplied from the replenishment water tank 80 is controlled according to the supply amount of the replenishment developer from the replenishment developer tank 70 and the replenishment developer is diluted at a predetermined magnification in a developing tank (developing bath), which is not shown in the figure but is disposed in the automatic developing machine 10. However, the invention is not limited to this mode. The replenishment developer and the reclaimed water may be mixed in advance to dilute the replenishment developer at a predetermined magnification, and then the mixture may be supplied to the developing bath.

Further, plating waste liquids generated from plural automatic developing machines may be collected in one waste liquid concentration unit, and the obtained reclaimed water may be supplied to plural automatic developing machines as dilution water or rinse water.

As such, the invention is also advantageous in that, by utilizing the reclaimed water as replenishment water, the processing amount of the photosensitive planographic printing plate precursors to be appropriately subjected to platemaking process is increased, without supplying fresh dilution water and the like.

### [Planographic Printing Plate Precursor]

Hereinafter, the planographic printing plate precursor which can preferably be applied to the method of concentrating a platemaking waste liquid and recycling method of the invention is explained in detail. The planographic printing plate precursor has, on a support, an image recording layer containing thermoplastic polymer particles and a photothermal conversion agent.

Hereinafter, the configuration of the planographic printing plate precursor, which can be applied to the method of concentrating a platemaking waste liquid and recycling method of the invention, is explained.

### [Aluminum Support]

In the planographic printing plate precursor used in the invention, an aluminum plate is used as the support. A preferable aluminum plate is a pure aluminum plate or an alloy plate containing aluminum as the main component and a slight amount of foreign element. Further, a plastic film on which aluminum is laminated or vapor deposited may also be used.

Examples of the foreign element contained in the aluminum alloy include silicon, iron, manganese, copper, magnesium, chromium, zinc, bismuth, nickel, and titanium. The content of the foreign atom in the alloy is about 10% by mass or lower. In the invention, the aluminum used for the support is particularly preferably pure aluminum; however, since it is difficult to produce perfectly pure aluminum in terms of refining technologies, an aluminum plate containing a slight amount of foreign element may be used. In the invention, the aluminum plate applied to the support of the planographic printing plate precursor is not limited in terms of the composition thereof, and an aluminum plate formed from conventionally known materials can be utilized as appropriate.

The thickness of the aluminum plate used for the support of the planographic printing plate precursor in the invention is from about 0.05 mm to about 0.6 mm, preferably from 0.1 mm to 0.4 mm, and particularly preferably from 0.15 mm to 0.3 mm.

Regarding the aluminum plate used for the support, at least the surface on the side at which the image recording layer is formed is roughened.

Before surface-roughening the aluminum plate, if desired, a degreasing treatment is carried out, using, for example, a surfactant, an organic solvent or an alkaline aqueous solution, or the like, in order to remove rolling oil that is present on the surface.

The surface of the aluminum plate is subjected to a surface roughening treatment by various methods. Examples of the methods include a method of mechanically roughening a surface, a method of electrochemically dissolving and roughening a surface, and a method of chemically and selectively dissolving a surface. As the mechanical method, a known method, such as a ball polishing method, a brush polishing method, a blast polishing method, or a buffing polishing method, can be used. Further, as the electrochemically surface roughening method, a method in which surface roughening is performed in a hydrochloric acid or nitric acid electrolyte using alternating current or direct current is described. Moreover, a method using the two methods in combination as disclosed in JP-A No. H54-63902 can be utilized.

Surface roughening by the method as described above is preferably carried out within an extent such that the center line surface roughness (Ra) of the surface of the aluminum plate is from 0.3 µm to 1.0 µm. If necessary, the aluminum plate that has been surface-roughened is subjected to an alkali etching treatment using an aqueous solution of potassium hydroxide, sodium hydroxide, or the like, and further subjected to a neutralizing treatment, and thereafter, subjected to an anodic oxidizing treatment, if desired, in order to enhance abrasion resistance.

Regarding the kind of electrolyte used in the anodic oxidizing treatment of the aluminum plate, the use of various electrolytes that form a porous oxidized coating is possible. As the electrolyte, generally, sulfuric acid, hydrochloric acid, oxalic acid, chromic acid, or a mixed acid thereof is used. The concentration of the electrolyte is appropriately determined depending on the kind of the electrolyte.

The conditions for the anodic oxidizing treatment may variously vary depending on the kind of the electrolyte and cannot be defined simply, but generally, it would be sufficient to conduct the anodic oxidization under the following conditions. Namely, an electrolyte solution having an electrolyte concentration of from 1% by mass to 80% by mass is used, the liquid temperature is in a range of from 5°C to 70°C, the current density is in a range of from 5 A/dm² to 60 A/dm², the electric voltage is in a range of from I V to 100 V, and the electrolyzing time is in a range of from 10 seconds to 5 minutes.

The amount of the anodic oxidation coating to be formed by the anodic oxidization is preferably from 1.0 g/m² to 5.0 g/m², and particularly preferably from 1.5 g/m² to 4.0 g/m². When the amount of the anodic oxidation coating is within the above range, a sufficient printing durability can be obtained, the non-image area of the planographic printing plate is less likely to be damaged, and thus, the occurrence of a so-called "damage stain" in the non-image area caused by adhesion of ink to a damaged portion during printing is effectively suppressed.

After the anodic oxidizing treatment is finished, the aluminum surface is subjected to a hydrophilizing treatment, if necessary. An example of the hydrophilizing treatment of the support used in the invention is a method of treating using an alkali metal silicate (for example, an aqueous solution of sodium silicate) such as those disclosed in U.S. Patent Nos. 2,714,066, 3,181,461, 3,280,734, and 3,902,734. In this method, the support is dipped in an aqueous solution of sodium silicate or electrolyzed using the above aqueous solution. Other than the above, a method of treating using fluorinated potassium zirconate, which is disclosed in Japanese Patent Application Publication (JP-B) No. S36-22063, a method of treating using polyvinyl phosphonic acid, such as those disclosed in U.S. Patent Nos. 3,276,868, 4,153,461, and 4,689,272, or the like may be used.

The thickness of the support used in the invention is from about 0.05 mm to about 0.6 mm, preferably from 0.1 mm to 0.4 mm, and particularly preferably from 0.15 mm to 0.3 mm.

### [Image Recording Layer]

The planographic printing plate precursor to be used in the invention is not particularly limited, as long as the planographic printing plate precursor has, on a hydrophilic support, an image recording layer containing thermoplastic polymer particles and a photothermal conversion agent.

The image recording layer having the above configuration is a negative type image recording layer, in which the thermoplastic polymer particles that exist in the exposed area fuse with each other by exposure, to form an image area region, and in the unexposed area, the thermoplastic polymer particles are removed by development to form an non-image area region.

### [Thermoplastic Polymer Particles]

The image recording layer in the invention contains thermoplastic polymer particles (hereinafter, as appropriate, referred to as "polymer particles"). The polymer particles usable in the invention are preferably polymer particles which melt and fuse with each other by heat, and further, polymer particles, which have hydrophilic surfaces and are easily dispersed in water, are particularly preferable.

Examples of a thermoplastic resin that constitutes the polymer particles include polyethylene, polystyrene, polyvinyl chloride, polyvinylidene chloride, polymethyl (meth)acrylate, polyethyl (meth)acrylate, polybutyl (meth)acrylate, polyacrylonitrile, polyvinyl acetate, and latexes of a copolymer including the monomer that constitutes the above resin as the copolymerization component.

There is no particular limitation as to the treatment method for hydrophilizing the surface of the polymer particles. Examples include a method of adhering one or more compounds selected from the group consisting of hydrophilic polymers such as polyvinyl alcohol or polyethylene glycol, hydrophilic oligomers, hydrophilic low molecular weight compounds, and the like, to the surfaces of polymer particles, and the like.

Regarding preferable physical properties of the polymer particles, physical properties such that, when only the polymer particles are coated on a hard plate-like substrate, the contact angle (atmospheric water droplet) of the coating prepared by drying at a temperature lower than the solidification temperature of the polymer particles is smaller than the contact angle (atmospheric water droplet) of the coating prepared by drying at a temperature higher than the solidification temperature are preferable. Here, the "solidification temperature of the polymer particles" refers to a temperature at which the polymer particles fuse with each other. The solidification temperature of the polymer particles is preferably 70°C or higher, and more preferably 100°C or higher, when considering the stability over time.

It is preferable that the polymer particle is a polymer particle having a reactive functional group, for the purpose of enhancing the film strength of the image area. The polymer particle having a reactive functional group may be a polymer particle formed to include a resin having a reactive functional group, or a polymer particle obtained by introducing a reactive functional group into a polymer particle that does not have a reactive functional group, by a polymer reaction.

The polymer particle having a reactive functional group is not particularly limited, as long as the particle is configured to include a resin having a functional group capable of reacting with a functional group possessed by other polymer particle or a functional group possessed by other component in the image recording layer. Preferable examples thereof may include a latex particle having a reactive functional group and the like.

Examples of the reactive functional group include an ethylenically unsaturated group capable of undergoing a polymerization reaction (for example, an acryloyl group, a methacryloyl group, a vinyl group, an allyl group, or the like); an isocyanato group capable of undergoing an addition reaction or a blocked form thereof; a functional group having an active hydrogen atom, which is a reaction partner thereof (for example, an amino group, a hydroxyl group, a carboxyl group, or the like); an epoxy group capable of undergoing an addition reaction as the above; an amino group, a carboxyl group, and a hydroxyl group, each of which is capable of reacting with an epoxy group: a combination of a carboxyl group and a hydroxyl group or an amino group, which is capable of undergoing a condensation reaction; and a combination of an acid anhydride and an amino group or a hydroxyl group, which is capable of undergoing a ring opening addition reaction. However, the invention is not limited thereto, and functional groups that undergo any reaction may be employed, as long as the functional groups react each other to form a chemical bond.

The polymer particle having a reactive functional group may react via the reactive functional group possessed by the polymer particle, or in a case in which other component, for example, a hydrophilic resin described below, a low molecular weight compound, or the like, which exists in the image recording layer, has a reactive functional group, the polymer particle having a reactive functional group may react with the reactive functional group possessed by such a component. Alternatively, polymer particles may be made to react with each other, by using two or more kinds of polymer particles having different reactive functional groups that react with each other, in combination.

Examples of the polymer particle having a reactive functional group, which can be used in the image recording layer in the invention, may include polymer particles having a reactive functional group selected from the group consisting of an acryloyl group, a methacryloyl group, a vinyl group, an allyl group, an epoxy group, an amino group, a hydroxyl group, a carboxyl group, an isocyanato group, an acid anhydride, and a group in which the above group is blocked. Introduction of the reactive functional group into a polymer particle may be conducted at the time of polymerization to produce the polymer that constitutes the polymer particle, or may be conducted by utilizing a polymer reaction with respect to the polymer particle that is obtained after the polymerization.

In the case of introducing a reactive functional group at the time of polymerization to produce the polymer, it is preferable to undergo emulsion polymerization or suspension polymerization using a monomer having a reactive functional group, to produce a polymer particle.

Specific examples of the monomer having a reactive functional group may include allyl methacrylate, allyl acrylate, vinyl methacrylate, vinyl acrylate, glycidyl methacrylate, glycidyl acrylate, 2-isocyanatoethyl methacrylate, a blocked isocyanate thereof with alcohol or the like, 2-isocyanatoethyl acrylate, a blocked isocyanate thereof with alcohol or the like, 2-aminoethyl methacrylate, 2-aminoethyl acrylate, 2-hydroxyethyl methacrylate, 2-hydroxyethyl acrylate, acrylic acid, methacrylic acid, maleic anhydride, bifunctional acrylate, and bifunctional methacrylate. The monomer having a reactive functional group in the invention is not limited thereto.

Further, in producing the polymer particle having a reactive functional group, a monomer that does not have a reactive functional group but is copolymerizable with the monomer having a reactive functional group may be used in combination. Examples of the monomer that does not have a reactive functional group may include styrene, alkyl acrylate, alkyl methacrylate, acrylonitrile, and vinyl acetate. The monomer that does not have a reactive functional group in the invention is not limited thereto.

Examples of the polymer reaction, which is used in the case of introducing the reactive functional group after formation of a polymer particle, may include a polymer reaction described in WO 96/34316.

The polymer particles having a reactive functional group are preferably those capable of forming an image area by fusing with each other by heat, but are not limited thereto. It is preferable but not necessary that the polymer particles thermally fuse with each other, as long as a chemical reaction occurs by heat, to form a chemical bond between the polymer particles or between the polymer particle and a hydrophilic resin or low molecular weight compound, which exists in the image recording layer, such that a strong film that becomes an image area region can be formed.

The average particle diameter of the polymer particles in the invention is preferably from 0.01 µm to 20 µm, more preferably from 0.05 µm to 2.0 µm, and particularly preferably in a range of from 0.1 µm to 1.0 µm. When the average particle diameter of the polymer particles is within this range, an image area having a favorable resolution is formed, and the image recording layer exhibits favorable stability over time.

Note that, in the invention, for the average particular diameter of the polymer particles, a value measured by using a dynamic light scattering method is used.

The content of the polymer particles in the image recording layer in the invention is preferably 50% by mass or higher, more preferably 60% by mass or higher, and still more preferably 75% by mass or higher, with respect to the total solid content of the image recording layer. Considering that a photothermal conversion agent, a hydrophilic resin for stably retaining the polymer particles in the image recording layer, and the like are used together with the polymer particles, the content of the polymer particles is preferably 95% by mass or less.

### [Reaction Initiating Agent or Reaction Accelerating Agent]

In the case of using a polymer particle having a reactive functional group in the image recording layer in the invention, a reaction initiating agent or a reaction accelerating agent, which are compounds that initiates or accelerates the reaction of the reactive functional group possessed by the polymer particle, may be added to the image recording layer.

Examples of the reaction initiating agent or the reaction accelerating agent may include compounds that may generate a radical or a cation. Examples of the reaction initiating agent and the reaction accelerating agent include lophine dimers, trihalomethyl compounds, peroxides, azo compounds, onium salt compounds including a diazonium salt, a diphenyl iodonium salt, or the like, acylphosphine, and imido sulfonate.

The content of the reaction initiating agent or the reaction accelerating agent in the case of using a reaction initiating agent or a reaction accelerating agent in the image recording layer can be set within the range of from 1 % by mass to 20% by mass, with respect to the solid content of the image recording layer. The content is preferably in a range of from 3% by mass to 10% by mass. When the content is within this range, the developing property is not damaged, and a favorable reaction initiating or accelerating effect can be obtained.

### [Hydrophilic Resin]

A hydrophilic resin may be added to the image recording layer according to the invention. By the addition of a hydrophilic resin, the developing property becomes more favorable, and further, the film strength of the image recording layer itself is also further enhanced.

Examples of the hydrophilic resin include resins having a hydrophilic group such as hydroxyl, carboxyl, hydroxyethyl, hydroxypropyl, amino, aminoethyl, aminopropyl, or carboxymethyl.

Specific examples of the hydrophilic resin may include gum arabic, casein, gelatin, starch derivatives, carboxymethyl cellulose and a sodium salt thereof, cellulose acetate, sodium alginate, vinyl acetate-maleic acid copolymers, styrene-maleic acid copolymers, polyacrylic acids and salts thereof, polymethacrylic acids and salts thereof, homopolymers and copolymers of hydroxyethyl methacrylate, homopolymers and copolymers of hydroxyethyl acrylate, homopolymers and copolymers of hydroxypropyl methacrylate, homopolymers and copolymers of hydroxypropyl acrylate, homopolymers and copolymers of hydroxybutyl methacrylate, homopolymers and copolymers of hydroxybutyl acrylate, polyethylene glycols, hydroxypropylene polymers, polyvinyl alcohols, polyvinyl formal, polyvinyl butyral, polyvinyl pyrrolidone, homopolymers and copolymers of acrylamide, homopolymers and copolymers of methacrylamide, and homopolymers and copolymers of N-methylolacrylamide. Further, a hydrolyzed polyvinyl acetate having a hydrolysis degree of at least 60% by mass, and preferably at least 80% by mass, can be used as the hydrophilic resin in the invention.

The content of the hydrophilic resin in the case of using a hydrophilic resin in the image recording layer is preferably from 5% by mass to 40% by mass, more preferably from 10% by mass to 30% by mass, with respect to the solid content of the image recording layer. When the content is within this range, a favorable developing property and a favorable film strength can be obtained.

### [Photothermal Conversion Agent]

In the planographic printing plate precursor according to the invention, when a photothermal conversion agent is contained in the image recording layer, it becomes possible to record an image by laser light irradiation or the like. The photothermal conversion agent to be used is not particular limited, as long as the photothermal conversion agent is a substance that absorbs light in the wavelength region of the laser light source. For example, various pigments, dyes, metal particles, or the like can be used as the photothermal conversion agent. Particularly, a light absorbing substance having an absorption region at least at a portion of a wavelength region of from 700 nm to 1200 nm is preferable.

Examples of a pigment that serves as the photothermal conversion agent include black pigments, brown pigments, red pigments, purple pigments, blue pigments, green pigments, fluorescent pigments, metal powder pigments, and polymer bonded dyes. Specifically, an insoluble azo pigment, an azo lake pigment, a condensed azo pigment, a chelate azo pigment, a phthalocyanine pigment, an anthraquinone pigment, a perylene or perinone pigment, a thioindigo pigment, a quinacridone pigment, a dioxazine pigment, an isoindolinone pigment, a quinophthalone pigment, a dyeing lake pigment, an azine pigment, a nitroso pigment, a nitro pigment, a natural pigment, a fluorescent pigment, an inorganic pigment, carbon black, or the like may be used.

These pigments may be used without performing a surface treatment, or these pigments may be subjected to a surface treatment and used. Examples of the surface treating method may include a method of coating the pigment surface with a hydrophilic resin, a lipophilic resin, or the like; a method of adhering a surfactant; and a method of bonding a reactive material (for example, silica sol, alumina sol, a silane coupling agent, an epoxy compound, an isocyanate compound, or the like) to the pigment surface. The above surface treating methods are described in "Kinzokusekken no Seishitu to Oyo (Properties and Applications of Metal Soup)" (published by Saiwai Shobo), "Insatu Inki Gijutsu (Techniques for Printing Ink)" (CMC Publishing Co., Ltd., published in 1984), and "Saishin Ganryo Oyo Gijutsu (Applied Techniques for Latest Pigments)" (CMC Publishing Co., Ltd., published in 1986).

Among these pigments, pigments that absorb infrared ray are preferable from the viewpoint of being suitable for the use with a laser which emits infrared ray. As the pigment that absorbs infrared ray, carbon black is particularly preferable.

The particle diameter of the pigment to be used as the photothermal conversion agent is preferably in a range of from 0.01 µm to 1 µm, and more preferably in a range of from 0.01 µm to 0.5 µm.

Examples of the dye, which may be used as the photothermal conversion agent, include commercially available dyes and known infrared absorbing dyes described in literature (for example, "Senryo Binran (Handbook of Dyes)", edited by Yuki Gosei Kagaku Kyokai (The Society of Synthetic Organic Chemistry, Japan), published in 1970; "Kin-Sekigai Kyushu Shikiso (Near Infrared Absorption Dyes)" in "Kagaku Kogyo (Chemical Industry)" the May issue, 1986, pages 45 to 51; and "90-Nendai Kinousei Shikiso no Kaihatsu to Shijyodoko (90's Development and Market Trends of Functional Dyes)", chapter 2, item 2. 3 (1990), CMC Publishing Co., Ltd.) and patents. Specifically, infrared absorbing dyes, such as an azo dye, a metal complex salt azo dye, a pyrazolone azo dye, an anthraquinone dye, a phthalocyanine dye, a carbonium dye, a quinoneimine dye, a polymethine dye, or a cyanine dye, are preferable.

Further, examples of the dye, which may be used as the photothermal conversion agent, may include a cyanine dye described in JP-A No. S58-125246, JP-A No. S59-84356, JP-A No. S60-78787, and the like; a methine dye described in JP-A No. S58-173696, JP-A No. S58-181690, JP-A No. S58-194595, and the like; a naphthoquinone dye described in JP-A No. S58-112793, JP-A No. S58-224793, JP-A No. S59-48187, JP-A No. S59-73996, JP-A No. S60-52940, JP-A No. S60-63744, and the like; a squarylium dye described in JP-A No. S58-112792 and the like; a cyanine dye described in U.K. Patent No. 434,875; a dye described in U.S. Patent No. 4,756,993; a cyanine dye described in U.S. Patent No. 4,973,572; a dye described in JP-A No. H10-268512; and a phthalocyanine compound described in JP-A No. H11-235883.

Further, as the dye, a near infrared absorbing sensitizer described in U.S. Patent No. 5,156,938 is also preferably used. Examples of the dye further include a substituted arylbenzo(thio) pyrylium salt described in U.S. Patent No. 3,881,924; a trimethine thiapyrylium salt described in JP-A No. S57-142645; a pyrylium compound described in JP-A Nos. S58-181051, S58-220143, S59-41363, S59-84248, S59-84249, S59-146063, and S59-146061; a cyanine dye described in JP-ANo. S59-216146; a pentamethine thio pyrylium salt described in U.S. Patent No. 4,283,475; and a pyrylium compound described in JP-B Nos. H5-13514 and H5-19702.

A commercially available product may be used as the dye which is used as the photothermal conversion agent. Examples of the commercially available product, which may be preferably used, include EPOLIGHT III-178, EPOLIGHT III-130, and EPOLIGHT III-125 (all trade names, manufactured by Epolin, Inc.)

Among these infrared absorbing dyes, a cyanine dye having sulfonic acid or a salt thereof is preferably used.

Hereinafter, specific examples of the infrared absorbing dye, which can be used in the image recording layer in the invention, are shown; however, the invention is not limited thereto.

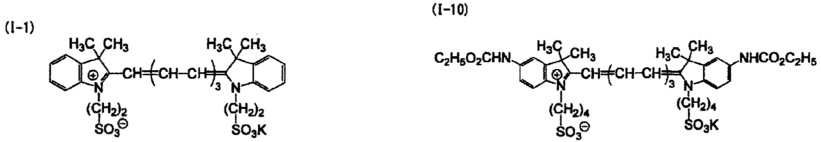

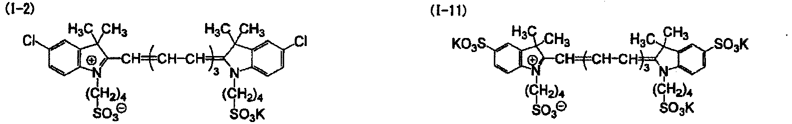

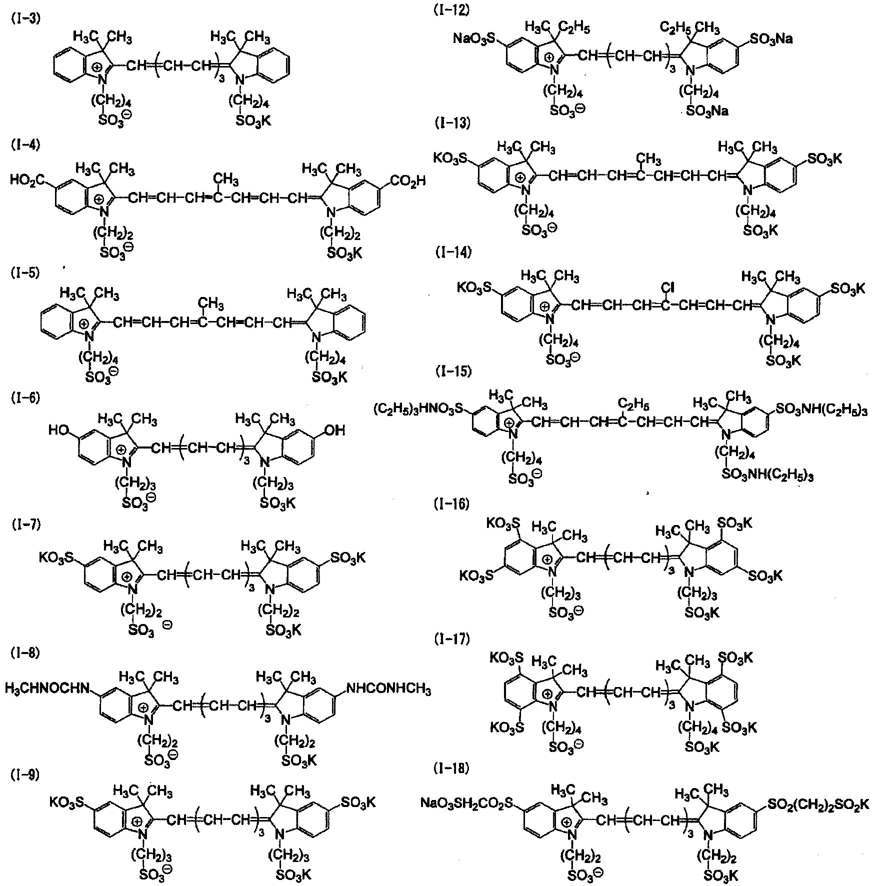

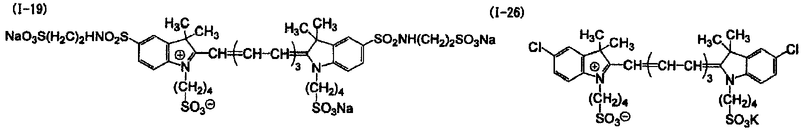

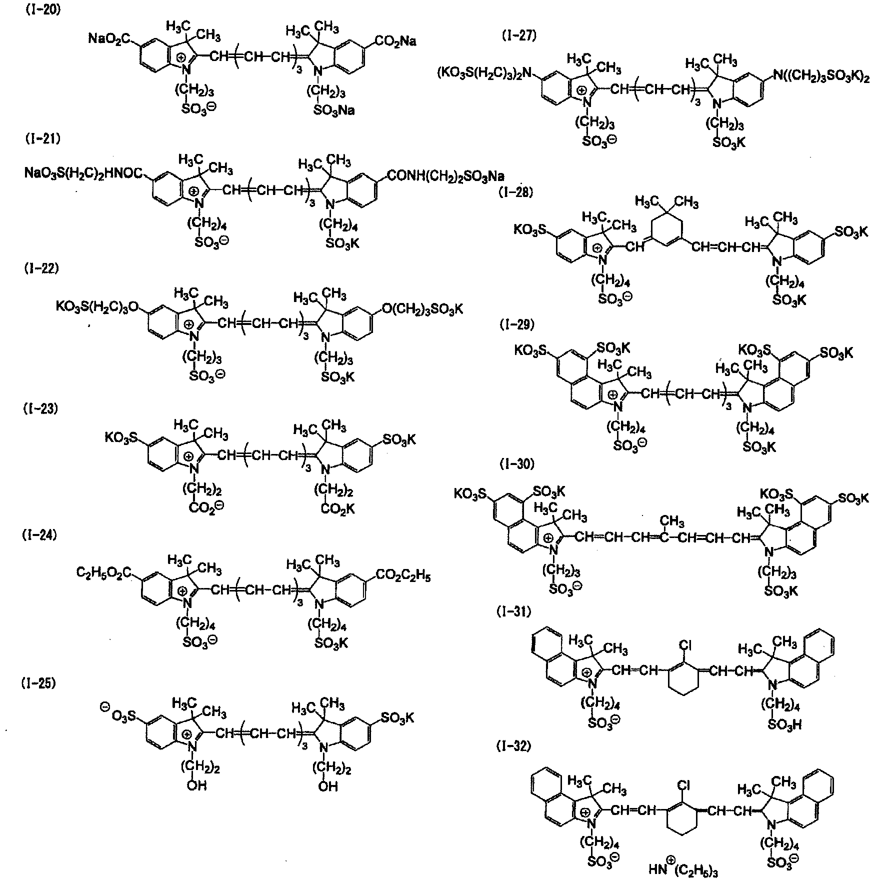

The photothermal conversion agent can be contained in the image recording layer up to 30% by mass. The content of the photothermal conversion agent is preferably from 5% by mass to 25% by mass, and particularly preferably from 7% by mass to 20% by mass. When the content of the photothermal conversion agent is within the above range, a favorable sensitivity enhancing effect can be obtained.

### [Low Molecular Weight Compound Having Reactive Functional Group]

In the case of using a polymer particle having a reactive functional group, the image recording layer in the invention may further contain a low molecular weight compound (hereinafter, may be referred to as a "reactive low molecular weight compound") having a functional group capable of reacting with the reactive functional group possessed by the polymer particle and a protective group thereof.

Examples of the reactive low molecular weight compound include compounds which have a molecular weight of 600 or less and have a polymerizable unsaturated group, a hydroxyl group, a carboxyl group, a carboxylate group, an acid anhydride group, an amino group, an epoxy group, an isocyanato group, or a blocked isocyanato group in a molecule thereof.

The reactive low molecular weight compound having a polymerizable unsaturated group is a radially polymerizable compound having at least one ethylenically unsaturated double bond and is selected from compounds having at least one terminal ethylenically unsaturated bond, preferably having two or more terminal ethylenically unsaturated bonds. Such a compound group is widely known in the art, and these compounds can be used in the invention without any particular limitation. These compounds are in the chemical form of, for example, a monomer, a prepolymer, that is, a dimer, a trimer, or an oligomer, or a mixture thereof.

Examples of monomers and copolymers thereof include an unsaturated carboxylic acid (for example, acrylic acid, methacrylic acid, itaconic acid, crotonic acid, isocrotonic acid, maleic acid, or the like), an ester thereof, and an amide thereof. Preferably, an ester of an unsaturated carboxylic acid and an aliphatic polyhydric alcohol compound, or an amide compound which is a reaction product between an unsaturated carboxylic acid and an aliphatic polyvalent amine compound is used.

Further, an addition reaction product between an unsaturated carboxylic acid ester or amide compound, each having a nucleophilic substituent, such as a hydroxyl group, an amino group, or a mercapto group, and a monofunctional or polyfunctional isocyanate or an epoxy; a dehydration condensation reaction product between such an unsaturated carboxylic acid ester or amide compound and a monofunctional or polyfunctional carboxylic acid, or the like is also preferably used.

Moreover, an addition reaction product between an unsaturated carboxylic acid ester or amide, each having an electrophilic substituent, such as an isocyanato group or an epoxy group, and a monofunctional or polyfunctional alcohol, amine, or thiol; and a substitution reaction product between an unsaturated carboxylic acid ester or amide, each having a leaving substituent, such as a halogen group or a tosyloxy group, and a monofunctional or polyfunctional alcohol, amine, or thiol are also preferable. In addition, as another example, it is possible to use a group of compounds which are reaction products obtained by substituting the unsaturated carboxylic acids described above with unsaturated phosphonic acid, styrene, or the like and similarly undergoing reaction.

Hereinafter, the reactive low molecular weight compound having a polymerizable unsaturated group, which may be used in the invention, is explained in detail with specific examples.

Specific examples of a radical-polymerizable compound which is an ester of an aliphatic polyhydric alcohol compound and an unsaturated carboxylic acid include, as acrylic acid esters, ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri(acryloyloxypropyl) ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol hexaacrylate, sorbitol triacrylate, sorbitol tetraacrylate, sorbitol pentaacrylate, sorbitol hexaacrylate, tri(acryloyloxyethyl) isocyanurate, and a polyester acrylate oligomer.

Examples of methacrylic acid esters include tetramethylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, sorbitol trimethacrylate, sorbitol tetramethacrylate, bis[p-(3-methacryloyloxy-2-hydroxypropoxy)phenyl] dimethyl methane, and bis[p-(methacryloyloxyethoxy)phenyl] dimethyl methane.

Examples of itaconic acid esters include ethylene glycol diitaconate, propylene glycol diitaconate, 1,3-butanediol diitaconate, 1,4-butanediol diitaconate, tetramethylene glycol diitaconate, pentaerythritol diitaconate, and sorbitol tetraitaconate.

Examples of crotonic acid esters include ethylene glycol dicrotonate, tetramethylene glycol dicrotonate, pentaerythritol dicrotonate, and sorbitol tetracrotonate.

Examples of isocrotonic acid esters include ethylene glycol diisocrotonate, pentaerythritol, diisocrotonate, and sorbitol tetraisocrotonate.

Examples of maleic acid esters include ethylene glycol dimaleate, triethylene glycol dimaleate, pentaerythritol dimaleate, and sorbitol tetramaleate.

As an example of other ester, for example, an ester of an aliphatic alcohol, which is described in JP-B No. S46-27926, JP-B No. S51-47334, and JP-A No. S57-196231; a compound having an aromatic skeleton, which is described in JP-A No. S59-5240, JP-A No. S59-5241, and JP-A No. H2-226149; a compound containing an amino group, which is described in JP-ANo. H1-165613; or the like is also preferably used.

Specific examples of the monomer, which is an amide of an aliphatic polyvalent amine compound and an unsaturated carboxylic acid, include methylenebis-acrylamide, methylenebis-methacrylamide, 1,6-hexamethylenebis-acrylamide, 1,6-hexamethylenebis-methacrylamide, diethylenetriamine trisacrylamide, xylylenebisacrylamide, and xylylenebismethacrylamide.

Other preferable examples of the amide monomer may include compounds having a cyclohexylene structure, which are described in JP-B No. S54-21726.

Further, a urethane addition-polymerizable compound produced using an addition reaction between isocyanate and a hydroxyl group is also preferably used. Specific examples of such a compound include a urethane compound containing two or more polymerizable unsaturated groups in one molecule, which is obtained by adding an unsaturated monomer having a hydroxyl group, which is represented by the following Formula (A), to a polyisocyanate compound having two or more isocyanato groups in one molecule, as described in JP-B No. S48-41708.

Formula (A) CH₂=C(Rm)COOCH₂CH(Rn)OH

(provided that each of Rm and Rn independently represents a hydrogen atom or CH₃.)

Further, urethane acrylates such as those described in JP-A No. S51-37193, JP-B No. H2-32293, and JP-B No. H2-16765, and urethane compounds having an ethylene oxide skeleton, which are described in JP-B No. S58-49860, JP-B No. S56-17654, JP-B No. S62-39417, and JP-B No. S62-39418 are also preferably used. Moreover, radical-polymerizable compounds having an amino structure or a sulfide structure in a molecule thereof, which are described in JP-A No. S63-277653, JP-A No. S63-260909, and JP-ANo. H1-105238, may be used.

Other examples of the reactive low molecular weight compound may include polyfunctional acrylates and methacrylates, for example, polyester acrylates, epoxy acrylates obtained by reacting an epoxy resin with (meth)acrylic acid, or the like, such as those described in JP-A No. S48-64183 and JP-B Nos. S49-43191 and S52-30490. Further, specific unsaturated compounds described in JP-B No. S46-43946 and JP-B Nos. H1-40337 and H1-40336, vinylphosphonic acid compounds described in JP-A No. H2-25493, and the like can also be described as preferable compounds. Further, in some cases, a compound having a perfluoroalkyl group, which is described in JP-A No. S61-22048, is also preferably used as the reactive low molecular weight compound. Furthermore, compounds described as photocurable monomers or oligomers in Nippon Secchaku Kyokaishi (Journal of Japan Adhesion Society), vol. 20, No. 7, pages 300 to 308 (1984) can also be used as the reactive low molecular compound in the invention.

Examples of an epoxy compound include, preferably, glycerin polyglycidyl ether, polyethylene glycol diglycidyl ether, polypropylene glycol diglycidyl ether, trimethylolpropane polyglycidyl ether, sorbitol polyglycidyl ether, and a polyglycidyl ether of bisphenol or polyphenol or a hydrogen additive thereof.

Examples of a compound having isocyanate may include tolylene diisocyanate, diphenylmethane diisocyanate, polymethylene polyphenyl polyisocyanate, xylylene diisocyanate, naphthalene diisocyanate, cyclohexane phenylene diisocyanate, isophorone diisocyanate, hexamethylene diisocyanate, cyclohexyl diisocyanate, and a compound which is a reaction product between the above compound and alcohol or an amine compound.

Examples of an amine compound include ethylenediamine, diethylenetriamine, triethylenetetramine, hexamethylenediamine, propylenediamine, and polyethyleneimine. Examples of a compound having a hydroxyl group may include a compound having terminal methylol, polyhydric alcohol such as pentaerythritol, bisphenols, and polyphenols. Examples of a compound having a carboxyl group include aromatic polyvalent carboxylic acids such as pyromellitic acid, trimellitic acid, or phthalic acid, and aliphatic polyvalent carboxylic acids such as adipic acid. Examples of an acid anhydride include pyromellitic dianhydride and benzophenone tetracarboxylic dianhydride.

The content of the low molecular weight compound having a reactive functional group is preferably from 5% by mass to 40% by mass, with respect to the total solid content of the image recording layer, and more preferably from 5% by mass to 20% by mass. When the content of the reactive low molecular weight is within the above range, the printing durability enhancing effect due to the enhancement of crosslinking density by the addition of the reactive low molecular weight compound can be sufficiently obtained, and there is no concern that developing property is deteriorated after the lapse of time.

### [Other Additives]

The image recording layer according to the invention may further include, if necessary, various compounds other than the above compounds.

For example, a dye having a large absorption in the visible region can be used as a colorant for the image, in order to easily distinguish the image area from the non-image area after the image formation.

Specific examples thereof may include dyes such as OIL YELLOW #101, OIL YELLOW #103, OIL PINK #312, OIL GREEN BG, OIL BLUE BOS, OIL BLUE #603, OIL BLACK BY, OIL BLACK BS, or OIL BLACK T-505 (all trade names, manufactured by Orient Chemical Industries, Co., Ltd.), Victoria Pure Blue, Crystal Violet (C.I. 42555), Methyl Violet (C.I. 42535), Ethyl Violet, Rhodamine B (C.I. 145170B), Malachite Green (C.I. 42000), or Methylene Blue (C.I. 52015), and dyes described in JP-A No. S62-293247. Further, pigments such as a phthalocyanine-based pigment, an azo-based pigment, or titanium oxide can also be used preferably.

The content of the dye having absorption in the visible region is preferably from 0.01% by mass to 10% by mass, with respect to the total solid content of the image recording layer.

Further, in order to clearly distinguish an image area from a non-image area after exposure, it is preferable that the image recording layer in the invention contains a compound that forms color or fades color by the change of various conditions, such as the pH or application of energy. Regarding the color-forming or color-fading compound, for example, a heat-acid generating agent selected from diazo compounds, diphenyl iodonium salts, and the like, and a compound that forms color or fades color by an acid, which is selected from leuco dyes (leuco Malachite Green, leuco Crystal Violet, a lactone form of leuco Crystal Violet, and the like), pH-induced color changing dyes (for example, Ethyl Violet, Victoria Pure Blue BOH, and the like) and the like, are used in combination.

Further, it is desired that a small amount of thermal polymerization inhibitor is added during preparation or storage of the image recording layer coating liquid, in order to inhibit unnecessary thermal polymerization of the ethylenically unsaturated compound.

Examples of the thermal polymerization inhibitor, which may be preferably used in the invention, include hydroquinone, p-methoxyphenol, di-t-butyl-p-cresol, pyrogallol, t-butyl catechol, benzoquinone, 4,4'-thiobis(3-methyl-6-t-butylphenol), 2,2'-methylenebis(4-methyl-6-t-butylphenol), and N-nitroso-N-phenylhydroxyamine aluminum salt.

In the case of using a thermal polymerization inhibitor in the image recording layer, the content of the thermal polymerization inhibitor is preferably from about 0.01% by mass to about 5% by mass, with respect to the total mass of the components of the image recording layer.

Moreover, the image recording layer in the invention can contain, if necessary, a plasticizer in order to impart flexibility and the like to the coated film. Examples of the plasticizer which can be used in the invention include polyethylene glycol, tributyl citrate, diethyl phthalate, dibutyl phthalate, dihexyl phthalate, dioctyl phthalate, tricresyl phosphate, tributyl phosphate, trioctyl phosphate, and tetrahydrofurfuryl oleate.

### [Solvent for Coating]

The image recording layer in the invention is formed by dispersing or dissolving each of the necessary components described above in a solvent, to prepare a coating liquid, and coating the coating liquid on a hydrophilic support.

Examples of the solvent to be used for preparing the image recording layer coating liquid may include ethylene dichloride, cyclohexanone, methyl ethyl ketone, methanol, ethanol, propanol, ethylene glycol monomethyl ether, 1-methoxy-2-propanol, 2-methoxyethyl acetate, 1-methoxy-2-propyl acetate, dimethoxyethane, methyl lactate, ethyl lactate, N,N-dimethylacetamide, N,N-dimethylformamide, tetramethylurea, N-methylpyrrolidone, dimethyl sulfoxide, sulfolane, γ-butyrolactone, toluene, and water, but it should be construed that the invention is not limited thereto.

These solvents may be used singly or in combination of two or more kinds thereof.

The solid content concentration of the image recording layer coating liquid is preferably from 1% by mass to 50% by mass.

### [Coating Method]

Various methods can be used as the method of coating the image recording layer coating liquid on the hydrophilic support. Examples of the coating method include bar coater coating, spin coating, spray coating, curtain coating, dip coating, air knife coating, blade coating, and roll coating.

The image recording layer coating liquid may contain a surfactant for improving coating property, for example, a fluorocarbon surfactant such as those described in JP-A No. S62-170950. In the case of using a fluorocarbon surfactant in the image recording layer coating liquid, the content of the fluorocarbon surfactant is preferably in a range of from 0.01% by mass to 1% by mass with respect to the total solid content of the image recording layer, and is more preferably in a range of from 0.05% by mass to 0.5% by mass.

### [Coating Amount of Image Recording Layer]

The coating amount (solids content) of the image recording layer on the support, which is obtained after coating and drying, varies depending on the use, but generally, the coating amount is preferably in a range of from 0.4 g/m² to 5.0 g/m². In general, when the coating amount gets smaller, the apparent sensitivity becomes greater, but the coating property of the image recording layer that performs the function of image recording is deteriorated. Therefore, when the coating amount after drying is within the above range, the balance between the sensitivity and the coating property of the image recording layer is favorable.

### [Platemaking of Photosensitive Planographic Printing Plate Precursor]

Hereinafter, a method of platemaking a photosensitive planographic printing plate precursor having an image recording layer is explained in the order of operations.

### [Platemaking]

A planographic printing plate is produced by subjecting the photosensitive planographic printing plate precursor used in the invention to imagewise exposure (imagewise exposing step) and processing (platemaking step) using a developer. In the waste liquid concentrating method of the invention and the recycling method of the invention, by using a specific developer as described above, desensitization, which is generally performed as a post-treatment after development, is conducted in one step together with development in an automatic developing machine.

As described above, the process relating to the platemaking step using a developer may be repeatedly performed two or more times.

### [Imagewise Exposing Step]

The photosensitive planographic printing plate precursor used in the invention is imagewise exposed through infrared laser light scanning based on digital data, or the like.

The wavelength of the exposure light source is preferably from 750 nm to 1400 nm.

In the invention, a photosensitive planographic printing plate precursor containing an infrared absorbent, which is a sensitizing dye having absorption in a wavelength region of from 750 nm to 1400 nm, is used, and by exposing light of the above wavelength region, an image is formed with high sensitivity.

As the light source of a wavelength of from 750 nm to 1400 nm used in this step, a solid laser or a semiconductor laser, which radiates infrared ray, is preferably used.

The mechanism of the exposure with the infrared laser may be any of an internal drum system, an external drum system, a flat bed system, or the like.

### [Platemaking Step]

The specific developer described above can be used as a developer or a replenishment developer for the photosensitive planographic printing plate precursor that has been exposed to light and, as described above, it is preferable to apply the specific developer to the development section of the automatic developing machine, to undergo platemaking process.

In the case of performing development using an automatic developing machine, since the developer is fatigued according to the processing amount, a replenishment system may be applied, with which the processing capacity of the developer is restored by supplying a replenishment developer or a fresh developer. This replenishment system is preferably applied also to the recycling method of the invention.

The platemaking process in the invention can be suitably carried out by using an automatic developing machine equipped with a developer supplying means and a scrubbing member.

Any automatic developing machine may be used as far as the automatic developing machine includes a means for applying at least one developer to the surface of a planographic printing plate precursor, and a developer is applied to the surface of the planographic printing plate precursor that has undergone exposure. Examples of the means for applying a developer to the surface of a planographic printing plate precursor include means of, for example, spraying using a spray, a shower or the like, jetting, immersion into a developing bath, or the like.

The development section that applies the developer to the planographic printing plate precursor that has undergone exposure, may include at least one roller for rubbing the developer against the plate surface in addition to the developer applying means or for brushing. It is preferable that two or more rollers are disposed in one development section.

The developer used in the development section is applied to the planographic printing plate precursor that has undergone exposure, and then, the developer is collected in a tank. The developer in the tank can be repeatedly used. Regarding the developer collected in the tank of the automatic developing machine, in a case in which the amount of the developer in the tank is reduced, due to the lapse of time or due to being used for the platemaking process, if necessary, a replenishment developer is added to the tank of the automatic developing machine, whereby replenishment of a developer is carried out. The developer whose activity is lowered is discharged from the tank and is subjected to the waste liquid concentrating step, as described below.

In the platemaking step described above, the protective layer and the image recording layer in the unexposed area are removed all together, and the image area thus formed, that is, the surface of the image area that remains on the plate surface, is subjected to desensitization using the developer described above. Accordingly, it is not necessary to perform desensitization especially in another step, and thus the planographic printing plate obtained after the development process can be immediately set on a printing machine and subjected to printing.

Namely, by using the above developer, which contains a surfactant and has regulated contents of organic solvents, as a developer, development and desensitization are conducted in one step, in the platemaking step, and therefore, a post-water washing step is not particularly needed, and a drying step can be carried out immediately. Note that, a post-water washing step may be carried out, if desired. However, in the case of carrying out a post-water washing step, it is preferable to further carry out desensitization, after the post-water washing step.

After the development process, it is preferable that the drying process is conducted after removing the excess developer using a squeeze roller.

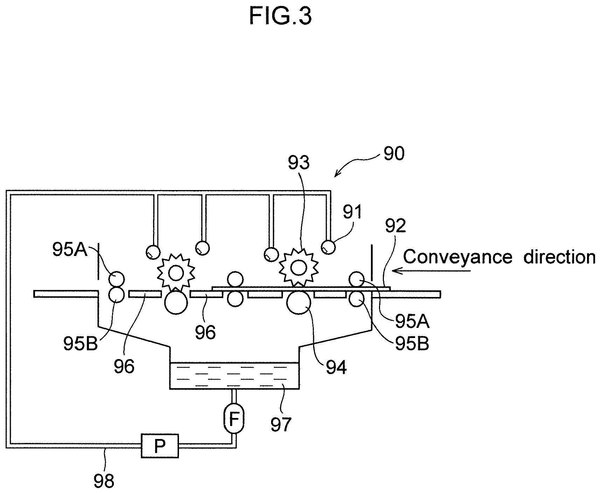

An example of the first mode of the automatic developing machine used in the waste liquid concentrating method and recycling method of the invention is briefly explained with reference to Fig. 3.

The automatic developing machine 90 described in Fig. 3 includes an application means (a spray pipe) 91 that sprays a developer to a planographic printing plate precursor. The planographic printing plate precursor 92 that has undergone exposure is conveyed along the conveyance direction expressed in arrow to a development section of the automatic developing machine 90, and in the development section, the developer is sprayed to the surface of the planographic printing plate precursor (plate surface) that has undergone exposure, by using the application means 91.

The automatic developing machine 90 is provided with a rotating brush roll 93, a receiving roll 94, a pair of conveying rolls 95A and 95B, and a conveyance guide plate 96. An excess of the developer, which is applied to the plate surface of the planographic printing plate precursor, is held in a processing liquid tank 97, after the application.

In the automatic developing machine 90 according to the present exemplary embodiment, first, the planographic printing plate precursor that has undergone exposure (hereinafter, as appropriate, referred to as "plate 92") is conveyed and supplied, from a plate feeding table to the development section. The plate 92 is conveyed to the inside of the development section in a state of being held at the nip portion of the pair of conveying rollers 95A and 95B which rotate in opposite directions to each other. The plate 92 that has been discharged from the nip portion and conveyed, moves on the conveyance guide plate 96.

In this process, the developer used in the invention is supplied from the spray pipe 91, which serves as the developer application means, onto the plate 92. Note that, the excess portion of the developer supplied from the spray pipe 91 falls downwards, and is stored in the processing liquid tank 97 that is provided below the conveyance guide plate 96. The developer stored in the processing liquid tank 97 passes through a filter (F) that is provided in a pipe path 98 to remove solid matters, and then is supplied again onto the plate 92 from the spray pipe 91 through a pump P.

When the concentration of active products, which are removed from the plate surface of the planographic printing plate precursor due to development, in the developer is lower than the desired level, it is possible to recover the activity of the developer to the desired level, by adding a concentrated developer to the developer as a replenishment solution. When the concentration of the active products in the developer is higher than the desired level, or when the viscosity of the developer is increased due to the active products or the like, or when the volume of the developer gets lower than the desired level due to, for example, evaporation of solvents or water, it is possible to dilute the developer with water. As the water to be used for dilution, the reclaimed water that is produced through the above-described development waste liquid concentrating step and the reclaimed water producing step is preferably used.

Further, when time has passed, and the activity of the developer gets lower to reach a level that is difficult to adjust by the addition of the above replenishment developer or the like, such a developer, or an excess developer produced due to the supply of the replenishment developer is discharged through a pipe, which is not shown in the figure, and is subjected to the development waste liquid concentrating step.

Next, the plate 92 further passes through the nip portion between the rotating brush roll 93 and the receiving roll 94 that works together with the rotating brush roll. In this process, the unexposed area region in the plate 92 is physically removed by rubbing with the rotating brush roll 93 which functions as the rubbing member. Furthermore, since the developer used in the preceding step exists on the plate 92, removal of the unexposed area is carried out extremely efficiently and, at the same time, the surface of the remained exposed area region (image area) is desensitized. As a result, residues of the image recording layer, which has been peeled and removed, never exist on the plate 92. Thus, in the plate 92, an image corresponding to the laser exposure is formed, and the resulting plate is carried out from the automatic developing machine 90.

Regarding the automatic developing machine 90 in Fig. 3, as shown in the figure, the automatic developing machine 90 is provided with plural rotating brush rolls 93, plural spray pipes 91, and the like. In one development section, the step of applying a developer using the spray pipe 91 and the step of rubbing using the rotating brush roll 93 are each carried out twice. Thus, production of planographic printing plates is carried out efficiently and certainly.

Accordingly, the planographic printing plate obtained by platemaking can be used for printing as it is, and moreover, can form a high quality image.

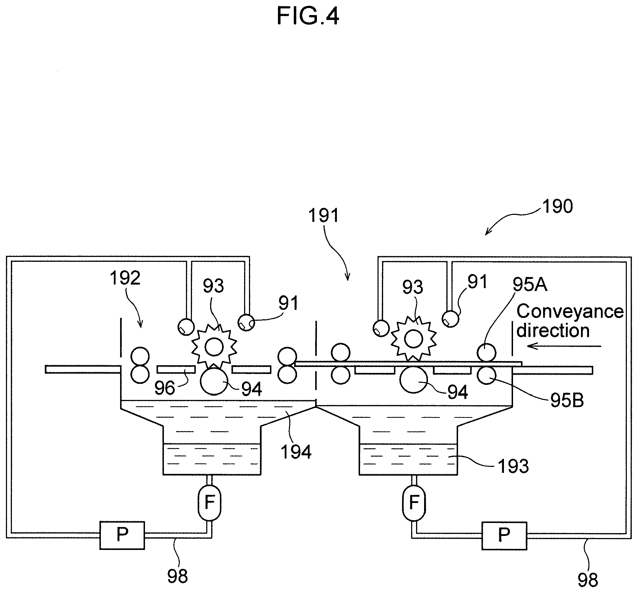

Fig. 4 is a conceptual diagram showing a mode in which the automatic developing machine 90 shown in Fig. 3 has two development sections. The automatic developing machine 190 shown in Fig. 4 has a first development section 191 and a second development section 192. In the automatic developing machine 190, with regard to the planographic printing plate precursor that has been imagewise exposed with infrared laser, as explained in Fig. 3, first, the developer that is used in the invention is supplied onto the plate 92 from a spray pipe 91 in the first development section 191. The excess portion of the developer that is supplied from the spray pipe 91 falls downwards, and is stored in a processing liquid tank 193 that is provided below the conveyance guide plate 96. The developer stored in the processing liquid tank 193 passes through a filter (F) that is provided in a pipe path 98 to remove solid matters, and then is supplied again onto the plate 92 from the spray pipe 91 through a pump P.

Thereafter, the plate 92 is conveyed from the first development section 191 to the second development section 192, and the developer used in the invention is supplied onto the plate 92 from the spray pipe 91, as in the first development section 191.

In the present exemplary embodiment, a structure of a cascade system is employed, and the developer used for developing the plate 92 in the first development section 191 and the second development section is present in a tank 193 of the first development section and a tank 194 of the second development section 192. Since each development section has an individual supply system, with respect to the plate 92 in which development process has proceeded in some extent in the development section 191, a developer is applied from the supply system of a developer having high activity in the second development section 192. Accordingly, a planographic printing plate having a higher image quality can be obtained. Further, in this system, as shown in Fig. 4, when a replenishment developer is added to the inside of the second development section, the developer in the tank 194 of the second development section 192 overflows to the tank 193 of the first development section 191.

Moreover, if desired, a replenishment developer can be added to the first development section 191. This replenishment developer may be the same as the replenishment developer added to the second development section 192. Alternatively, it is also possible to supply another replenishment developer. Water may be added to the first development section 191, and further, to the development section 192, thereby diluting the developer. The above water is preferably reclaimed water that is produced through the above-described development waste liquid concentrating step and the reclaimed water producing step.

As described above, by repeating plural times the platemaking process in the invention, in which development and desensitization are conducted in one step by using a specific developer, a developer which includes less amount of impurities such as development scum or the like contacts the plate 92 in the development section (in Fig. 4, the second development section 192) on the downstream side. Thus, the removability of the non-image area on the plate 92 is further improved. Further, since desensitization of the image area surface is repeatedly conducted, the image quality of the image formed is further improved.

Note that, although the above mode is explained by giving illustration of the case of performing twice the developing step, the invention is not limited thereto. The development step may be performed three times or more, and in this case, an automatic developing machine including a first development section, a second development section, and a third development section may be used.

Examples of the automatic developing machine as described above may include AZURA CX 125 (trade name, manufactured by Agfa-Gevaert NV) and the like.

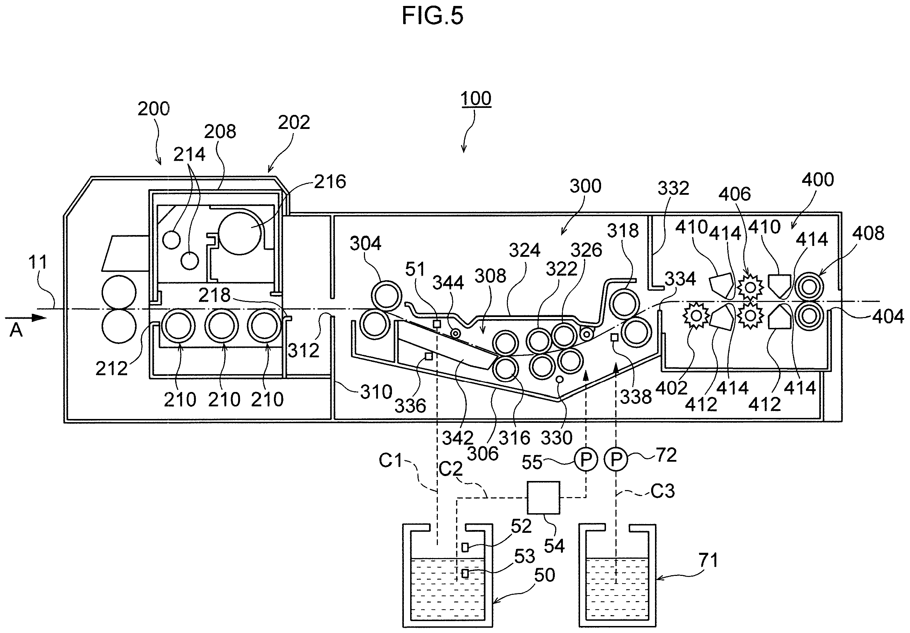

An example of the automatic developing machine according to another exemplary embodiment, which is used in the waste liquid concentrating method and recycling method of the invention is briefly explained with reference to Fig. 5.

The automatic developing machine 100 shown in Fig. 5 is equipped with a chamber in which the external shape is formed by a frame 202. Inside the chamber in which the external shape is formed by the frame 202, a preheating (preheat) section 200 , a development section 300, and a drying section 400, which are successively arranged along the conveyance direction (arrow A) of a conveyance path 11 of the photosensitive planographic printing plate precursor, are provided.

The preheating section 200 is equipped with a heating chamber 208 including an inlet port 212 and an outlet port 218. Inside the heating chamber 208, skewer shaped rollers 210, a heater 214, and a circulating fun 216 are disposed.

In the present exemplary embodiment, in which the above-described planographic printing plate precursor used in the invention is subjected to platemaking process, it is preferable that preheating in the preheating section 200 is not conducted. Accordingly, an automatic developing machine which does not include the preheating section 200 that is included in the automatic developing machine 100 described in Fig. 5, but includes the development section 300 and the drying section 400 in Fig. 5 is also preferably applied to the invention.

The development section 300 is separated from the preheating section 200 by an outer plate panel 310, and the outer plate panel 310 is provided with a slit-like insertion opening 312.

Inside the development section 300, a processing tank 306 having a developing tank (developing bath) 308 filled with the developer, and a pair of inserting rollers 304 that guides the photosensitive planographic printing plate precursor toward the inside of the processing tank 306 are provided. The upper part of the developing bath 308 is covered with a shielding cover 324.

Inside the developing bath 308, a guide roller 344, a guide member 342, a pair of in-liquid rollers 316, a pair of brush rollers 322, a pair of brush rollers 326, a pair of carrying-out rollers 318 are provided in this order from the upstream side in the conveyance direction. The photosensitive planographic printing plate precursor that has been conveyed to the inside of the developing bath 308 is immersed in the developer, and is passed through between the pairs of brush rollers 322 and 326, which rotate, whereby the non-image area is removed.

A spray pipe 330 is provided below the pairs of brush rollers 322 and 326. A pump (not shown in the figure) is connected to the spray pipe 330, so that the developer in the developing bath 308 is sucked by the pump, and is spouted into the developing bath 308 from the spray pipe 330.

On the side wall of the developing bath 308, an overflow opening 51 is provided at the upper end of a first circulation pipe C1, and the excess developer flows in the overflow opening 51, passes through the first circulation pipe C1, and is discharged to an external tank 50 that is provided outside the development section 300.

A second circulation pipe C2 is connected to the external tank 50, and a filter unit 54 and a developer supplying pump 55 are provided in the second circulation pipe C2. The developer is supplied from the external tank 50 to the developing bath 308 by the developer supplying pump 55. Further, an upper limit liquid level gauge 52 and a lower limit liquid level gauge 53 are provided inside the external tank 50.

The developing bath 308 is connected to a replenishment water tank 71 through a third circulation pipe C3. A water replenishing pump 72 is provided in the third circulation pump C3, and the water stored in the replenishment water tank 71 is supplied to the developing bath 308 by this water replenishing pump 72.

A liquid temperature sensor 336 is provided at the upstream side of the pair of in-liquid rollers 316, and a liquid surface level gauge 338 is provided at the upstream side of the pair of carrying-out rollers 318.

A slit-like insertion opening 334 is provided on a partition plate 332 that is disposed between the development section 300 and the drying section 400. Further, a shutter (not shown in the figure) is provided in the pathway between the development section 300 and the drying section 400. When the planographic printing plate does not pass through the pathway, the pathway is closed by the shutter.

In the drying section 400, a support roller 402, ducts 410 and 412, a pair of conveying rollers 406, ducts 410 and 412, and a pair of conveying rollers 408 are provided in this order. A slit hole 414 is provided at each of the tips of the ducts 410 and 412. Further, the drying section 400 is provided with a drying means, which is not shown in the figure, such as a hot air supplying means or a heat generating means. The drying section 400 is provided with a discharge port 404, and the planographic printing plate dried by the drying means is discharged through the discharge port 404.

### [Method of Replenishing Replenishment Developer and Method of Replenishing Reclaimed Water]

Next, the replenishment developer is explained.

The term "development initiating liquid" used in this specification means an unprocessed developer, unless otherwise specified. Further, the term "replenishment developer" means a replenishment liquid for development, which is added to a developer in the developing bath, the developer being deteriorated as a result of development of photosensitive planographic printing plate precursors, absorption of carbon dioxide, or the like.

The composition of the replenishment developer is basically the same composition as the composition of the development initiating liquid described above; however, if necessary, the replenishment developer may be highly active, compared with the development initiating liquid, in order to restore the activity of the deteriorated developer.

Fig. 1 is explained as an example. The development initiating liquid that is initially introduced in the developing bath of the automatic developing machine 10 in Fig. 1 is deteriorated due to the eluted substance (active product) generated by the processing of the photosensitive planographic printing plate precursor. Accordingly, in order to perform platemaking process continuously for a long time in the automatic developing machine 10, generally, it is necessary to supply at least one of water or a replenishment developer, which compensates for deterioration, intermittently or continuously, in order to maintain the development quality of the photosensitive planographic printing plate precursor.

Regarding specific replenishing methods, it is thought that there are four patterns described below. Namely, (1) a developer having the same concentration as the concentration of the development initiating liquid that is introduced initially is supplied; (2) a developer having the same concentration as the concentration of the development initiating liquid that is introduced initially, and water in an amount that corresponds to the volatilization amount are supplied; (3) a developer having a high concentration and water are supplied; and (4) only water in an amount that corresponds to the volatilization amount is supplied.

Here, the water to be supplied may be either fresh water or reclaimed water, and both fresh water and reclaimed water may be supplied.

In the case of (1), specifically, a concentrated developer is diluted with water in advance, to obtain a developer having the same concentration as the concentration of the development initiating liquid that is introduced initially, and then the resulting developer is supplied. In the cases of (2) and (3), the developer and water are supplied independently, and water is used for volatilization correction. In the case of (4), only water is supplied.

### [Other Platemaking Process]

In addition, in a platemaking process for producing a planographic printing plate from the photosensitive planographic printing plate precursor according to the invention, if necessary, the entire surface may be heated, before exposure, during exposure, or within a period after exposure until the initiation of development. Through such heating, the image forming reaction in the image recording layer is accelerated and, as a result, merits such that the sensitivity, printing durability, and the like are further improved and the sensitivity is more stabilized can be obtained.

Further, for the purpose of enhancing the image strength and printing durability, it is effective to perform post-heating of the entire surface or exposure of the entire surface, with respect to the image after development. Generally, it is preferable that heating before development is performed under mild conditions of 150°C or lower. When the temperature is too high, an undesired curing reaction may occur in the non-image area, and thus, problems such that stains are generated in the non-image area and the like may occur. Since the image recording layer of the planographic printing plate precursor applied to the method of the invention contains thermoplastic polymer particles, it is preferable that preheating is not performed, from the viewpoint of suppressing undesired fusion between the particles.

Extremely intense conditions are utilized in the heating after development. The heating temperature is generally in a range of from 200°C to 500°C. When the temperature is within the above range, a sufficient image strengthening action can be obtained, and occurrence of problems, such as deterioration of the support by heating or thermal decomposition of the image area, can be suppressed.

### EXAMPLES

Hereinafter, the present invention is explained in detail with reference to specific examples; however, it should be construed that the invention is not limited to the following description.

### [Examples 1 to 14 and Comparative Examples 1 to 9]

### 1. Production of Photosensitive Planographic Printing Plate Precursor 1

### [Production of Aluminum Support 1]

In order to remove the rolling oil on the surface of an aluminum plate (material: JIS A1050) having a thickness of 0.3 mm, the aluminum plate was subjected to a degreasing treatment at 50°C for 30 seconds using a 10% by mass aqueous solution of sodium aluminate. Then, the surface of the aluminum plate was roughened using three bundled nylon brushes having a fiber diameter of 0.3 mm and an aqueous suspension (specific gravity of 1.1 g/cm³) of pumice having a median diameter of 25 µm, and the resulting aluminum plate was washed well with water. The aluminum plate whose surface had been roughened was immersed in a 25% by mass aqueous solution of sodium hydroxide at 45°C for 9 seconds to perform etching, washed with water, and then further immersed in a 20% by mass aqueous solution of nitric acid at 60°C for 20 seconds, followed by washing with water. In this process, the amount of etching of the aluminum plate surface that had been roughened was about 3 g/m².

Subsequently, using an alternating current voltage of 60 Hz, an electrochemical surface roughening treatment was carried out continuously, with respect to the aluminum plate that had been etched. The electrolyte liquid used for the electrochemical surface roughening treatment was a 1% by mass aqueous solution of nitric acid (containing 0.5% by mass of aluminum ions). The liquid temperature of the electrolyte liquid was 50°C. Regarding the wave form of the alternating current power supply when applying an alternating current voltage of 60 Hz, a trapezoidal rectangular wave alternating current having a time TP, which is a time needed for the current value to reach from zero to the peak value, of 0.8 msec and having a duty ratio of 1:1 was used. Regarding the application of the alternating current voltage, a carbon electrode was used as the counter electrode. In this way, an electrochemical surface roughening treatment was carried out. Ferrite was used for the auxiliary anode (anode). The current density was 30 A/dm² in terms of the peak value of current, and 5% of the current flowing from the power supply was distributed to the auxiliary anode.

Regarding the amount of electricity in the electrolysis using the aqueous solution of nitric acid as the electrolyte liquid, the amount of electricity when the aluminum plate served as an anode was 175 C/dm².

The aluminum plate that had undergone the electrochemical surface roughening treatment was washed with water by spraying.

Then, another electrochemical surface roughening treatment was further carried out, with respect to the aluminum plate, by a method similar to the above-described electrochemical surface roughening by nitric acid electrolysis, using an electrolyte liquid of a 0.5% by mass aqueous solution of hydrochloric acid (containing 0.5% by mass of aluminum ions) having a liquid temperature of 50°C, under the condition that an amount of electricity when the aluminum plate served as an anode was 50 C/dm². Thereafter, the resulting aluminum plate was washed with water by spraying. On this aluminum plate, a direct current anodic oxidation coating of 2.5 g/m² was formed, using 15% by mass aqueous solution of sulfuric acid (containing 0.5% by mass of aluminum ions) as the electrolyte liquid, under the condition of a current density of 15 A/dm². Thereafter, the aluminum plate formed with an anodic oxidation coating was washed with water, followed by drying, to produce aluminum support 1.

The center line average roughness (Ra) of the aluminum support 1 thus obtained was measured using a needle having a diameter of 2 µm, and the roughness was 0.51 µm.

### [Production of Aluminum Support 2]

The aluminum support 1 was treated with a 1% by mass aqueous solution of sodium silicate at 20°C for 10 seconds, to produce aluminum support 2. The surface roughness (Ra) of the aluminum support 2 that had been treated with sodium silicate was measured, and the surface roughness was 0.54 µm.

The surface roughness (Ra) was measured in accordance with the method described in JIS B0601.

### [Formation of Image Recording Layer 1]

Image recording layer coating liquid 1 having the composition described below was prepared, and coated on the aluminum support 2 using a bar coater, followed by drying in an oven at 90°C for 60 seconds. In this way, image recording layer 1 having a dry coating amount of 1.3 g/m² was formed.

### <Image Recording Layer Coating Liquid 1>

- Thermoplastic polymer particles 8.5% by mass (acrylonitrile-styrene copolymer; average particle diameter: 60 nm)
- Infrared absorbing dye (A) (the structure shown below) 0.7% by mass
- Hydrophilic resin: polyacrylic acid (mass average molecular weight 20000) 0.5% by mass
- Colorant (B) (the structure shown below) 0.3% by mass
- Water 90% by mass

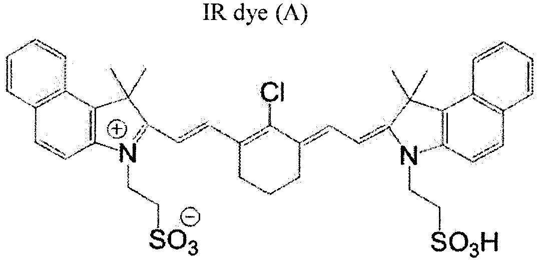

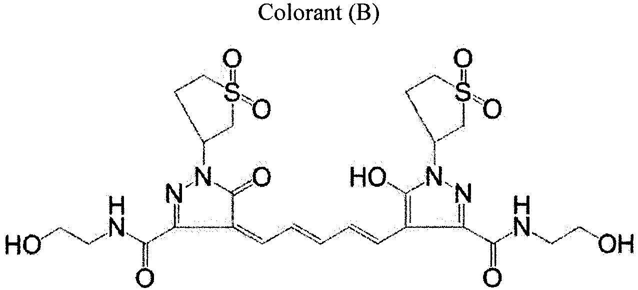

### [Exposure of Photosensitive Planographic Printing Plate Precursor]

The planographic printing plate precursor thus obtained was exposed to light, using a LUXEL PLATESETTER T-6000III (trade name) manufactured by FUJIFILM Corporation, which is an exposure apparatus mounted with an infrared semiconductor laser, under the conditions of an external drum revolution of 1000 rpm, a laser output of 70%, and a resolution of 2400 dpi (dot per inch).

Exposure images were prepared so as to include a solid image and a 50% dot chart of a 20 µm dot FM screen.

### [Platemaking Step]

The photosensitive planographic printing plate precursor I that had undergone exposure was subjected to platemaking process, using an automatic developing machine 190 having a structure shown in Fig. 4, and using the developer shown below. The automatic developing machine 190 has a first development section 191 and a second development section 192, and each of the development sections 191 and 192 has one rotating brush roll 93 which has an outer diameter of 50 mm and is produced by fixing fibers made of polybutylene terephthalate (diameter of fiber: 200 µm, length of fiber: 17 mm). The developer is supplied, from a spray pipe 91, to the surface of the photosensitive planographic printing plate precursor 1 that has undergone exposure. The rotating brush rolls 93 were rotated at 280 rotations per minute (circumferential speed of the tip of the brush: 0.73 m/sec) in the same direction as the conveyance direction, thereby performing removal of the non-image area in the image recording layer of the photosensitive planographic printing plate precursor 1 that had been applied with the developer. The temperature of the developer was 25°C. Conveyance of the photosensitive planographic printing plate precursor 1 was carried out at a conveyance speed of 140 cm/min.

The planographic printing plate obtained by the platemaking process was dried in the drying section, which is not shown in the figure. The drying temperature was 80°C.

### <Formulation of Developer>

- Surfactant (the surfactant described in Table 1) Amount described in Table 1
- Organic solvent having a boiling point of from 100°C to 300°C (the compound described in Table 1) Amount described in Table 1
- Dextrin (water-soluble resin) 4.0% by mass
- KH₂PO₄ 3.0% by mass
- Water (Remaining amount)
(KOH is added, to adjust the pH to 7.0)

The structures of the surfactants used in the developer are shown below. Compound (1) to Compound (6) are surfactants which are preferably used in the invention, and Compounds (R-1) and (R-2) are comparative surfactants which are outside the scope of the invention.

In Table 1, Developer 1 to Developer 14 are developers of a formulation defined in the invention, and Comparative Developer 1 to Comparative Developer 8 are developers of a formulation that is outside the scope of the invention.

**TABLE 1**

| Developer | Surfactant | | Organic Solvent Having a Boiling Point of from 100°C to 300°C | |
|---|---|---|---|---|
| | Compound | Content (%) | Compound | Content (%) |
| Developer 1 | (1) | 1 | Ethylene glycol | 0.5 |
| Developer 2 | (2) | 1 | Ethylene glycol | 0.5 |
| Developer 3 | (3) | 1 | Ethylene glycol | 0.5 |
| Developer 4 | (4) | 1 | Ethylene glycol | 0.5 |
| Developer 5 | (5) | 1 | Ethylene glycol | 0.5 |
| Developer 6 | (6) | 1 | Ethylene glycol | 0.5 |
| Developer 7 | (1) | 3 | Ethylene glycol | 0.5 |
| Developer 8 | (1) | 8 | Ethylene glycol | 0.5 |
| Developer 9 | (2) | 1 | Ethylene glycol | 1.5 |
| Developer 10 | (2) | 1 | Ethylene glycol | 0.1 |
| Developer 11 | (1) | 1 | Ethylene glycol | 0.5 |
| | (2) | 1 | | |
| Developer 12 | (4) | 2 | Ethylene glycol | 0.5 |
| | (6) | 1 | | |
| Developer 13 | (1) | 1 | Benzyl alcohol | 0.5 |
| Developer 14 | (1) | 1 | Glycerin | 0.5 |
| Comparative Developer 1 | (R-1) | 1 | none | |
| Comparative Developer 2 | (R-2) | 1 | none | |
| Comparative Developer 3 | (1) | 1 | none | |
| Comparative Developer 4 | (1) | 0.5 | Ethylene glycol | 0.5 |
| Comparative Developer 5 | (1) | 12 | Ethylene glycol | 0.5 |
| Comparative Developer 6 | (1) | 1 | Ethylene glycol | 3 |
| Comparative Developer 7 | (6) | 1 | Ethylene glycol | 3 |
| Comparative Developer 8 | (2) | 1 | Comparative solvent: Ethanol (boiling point: 78.3°C) | 0.5 |

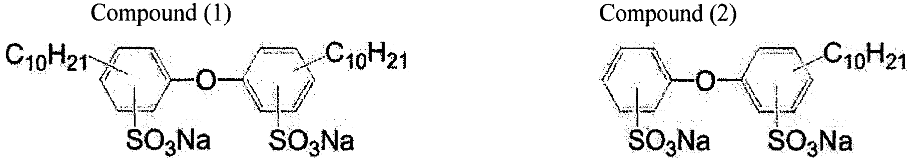

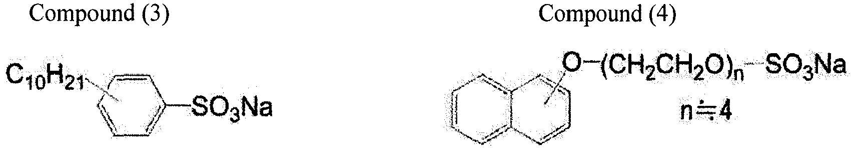

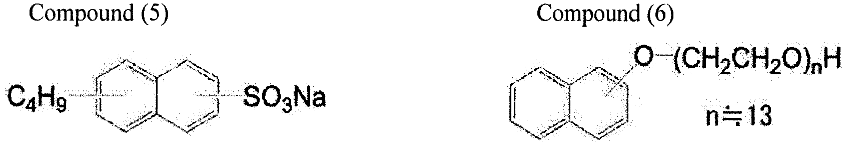

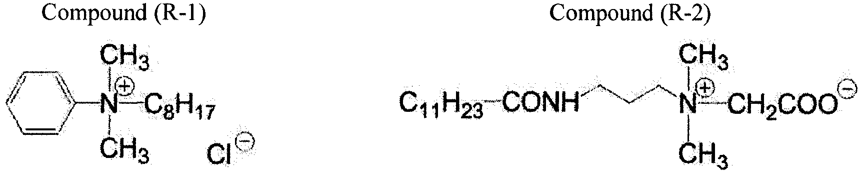

### [Waste Liquid Concentrating Step and Reclaimed Water Producing Step]

100 L of the developer (20 L to the developing bath, and 80 L to the external tank) were introduced into the automatic developing machine 190, and then, without performing exchange of the developer or replenishment, 1500 m² of the photosensitive planographic printing plate precursor 1 were subjected to platemaking process continuously. Thereafter, the developer used in the platemaking step was drained. The drained platemaking waste liquid was concentrated, using a waste liquid concentrating apparatus XR-2000 (trade name), manufactured by FUJIFILM Global Graphic Systems Co., Ltd., so as to obtain a concentration rate shown in Table 2 below (waste liquid concentrating step).

### (Evaluation of Planographic Printing Plate After Platemaking)

1500 m² of the photosensitive planographic printing plate precursor 1 were subjected to platemaking process continuously. Thereafter, the development state of the planographic printing plate obtained after the platemaking process was visually observed, and evaluated according to the following criteria.
No problem: the development state is favorable.
Poor development: the image recording layer remains in the non-image area due to poor development.
Over development: defects such as break or image failure occur in the image area, due to over development.
Generation of development scum: scum caused by separation of developed components and the like is generated in the developing bath, and the scum adheres to the plate.

As a result of the evaluation, as shown in Table 2 below, in a case in which only the results of the Evaluation on Platemaking is seen, regarding all the planographic printing plates obtained by performing platemaking according to the platemaking process of Example 1 to Example 14, or Comparative Example 9, using Developer 1 to Developer 14 defined in the invention, the results of the Evaluation on Platemaking were favorable. Further, also in the planographic printing plate obtained by performing platemaking according to the platemaking process of Comparative Example 8 using Comparative Developer 8, the result of the Evaluation on Platemaking was favorable.

On the other hand, regarding the planographic printing plates obtained by performing platemaking according to the platemaking process of Comparative Examples 1 to 7, using Comparative Developer 1 to Comparative Developer 7, which are outside the scope of the invention, the results of the Evaluation on Platemaking were inferior.

### (Evaluation of Concentrated Liquid in Waste Liquid Concentrating Step)

In concentrating the platemaking waste liquid in the waste liquid concentrating step, the foaming property and separation property of the platemaking waste liquid inside the concentrating apparatus were investigated.

It should be noted that the ratio of the volume of the platemaking waste liquid after the concentration to the volume of the platemaking waste liquid before the concentration is described as "concentration rate" in Table 2 below.

Regarding the waste liquids (Comparative Example 1 to Comparative Example 3) in which separation of solid matters had occurred during the concentration inside the concentrating apparatus in the waste liquid concentrating step, and the waste liquid (Comparative Example 5) in which foaming had occurred, the water obtained by cooling the steam separated due to concentration was not adequate as reclaimed water and was not usable as reclaimed water.

Also in the case of using Developer 1 that is defined in the invention, in Comparative Example 9, which was concentrated such that the concentration rate was 1/12, separation had occurred during the concentration of the plating waste liquid, and reclaimed water capable of being put to use was not obtained.

### (Reclaimed Water Producing Step and Evaluation of Reclaimed Water)

The steam that had been evaporated and separated in the waste liquid concentrating apparatus XR-2000 (trade name, manufactured by FUJIFILM Global Graphic Systems Co., Ltd.) was taken out, cooled, and condensed to obtain reclaimed water.

The presence or absence of organic solvent in the reclaimed water thus obtained was checked. The one, in which incorporation of a solvent is confirmed, exerts influence on the formulation of the developer, and thus, such one was not put to use as reclaimed water.

That is, in Comparative Example 8, in which platemaking process was performed using Comparative Developer 8 that does not contain an organic solvent having a boiling point within a range of from 100°C to 300°C but contains 0.5% by mass of ethanol (boiling point: 78.3°C), which is a solvent having a boiling point lower than 100°C, the solvent was incorporated in the reclaimed water, and thus the reclaimed water could not be put to use as reclaimed water.

### (Comprehensive Evaluation)

From these results, with respect to the method of concentrating a platemaking waste liquid, with which the result of the Evaluation on Platemaking in the planographic printing plate obtained by platemaking is favorable and there is no problem in the result of the Evaluation on Waste liquid concentrating step, and with which reclaimed water that can be put to use is obtained, the comprehensive evaluation result is rated as "A".

Further, with respect to the method of concentrating a platemaking waste liquid, with which there are problems in one or both of the result of the Evaluation on Platemaking and the result of the Evaluation on Waste liquid concentrating step, and which cannot be put to practical use, the comprehensive evaluation result is rated as "B".

The comprehensive evaluation result A indicates that the method of concentrating a platemaking waste liquid exhibits the effects of the invention, and is a method that can be put to practical use.

**TABLE 2**

| | Developer | Evaluation on Platemaking | Waste Liquid Concentration Rate | Evaluation on Waste Liquid Concentrating Step | Evaluation on Reclaimed Water | Comprehensive Evaluation |
|---|---|---|---|---|---|---|
| Example 1 | Developer 1 | No problem | 1/4 | No problem | No problem | A |
| Example 2 | Developer 2 | No problem | 1/4 | No problem | No problem | A |
| Example 3 | Developer 3 | No problem | 1/4 | No problem | No problem | A |
| Example 4 | Developer 4 | No problem | 1/4 | No problem | No problem | A |
| Example 5 | Developer 5 | No problem | 1/4 | No problem | No problem | A |
| Example 6 | Developer 6 | No problem | 1/4 | No problem | No problem | A |
| Example 7 | Developer 7 | No problem | 1/4 | No problem | No problem | A |
| Example 8 | Developer 8 | No problem | 1/4 | No problem | No problem | A |
| Example 9 | Developer 9 | No problem | 1/4 | No problem | No problem | A |
| Example 10 | Developer 10 | No problem | 1/4 | No problem | No problem | A |
| Example 11 | Developer 11 | No problem | 1/4 | No problem | No problem | A |
| Example 12 | Developer 12 | No problem | 1/4 | No problem | No problem | A |
| Example 13 | Developer 13 | No problem | 1/10 | No problem | No problem | A |
| Example 14 | Developer 14 | No problem | 1/2 | No problem | No problem | A |
| Comparative Example 1 | Comparative Developer 1 | Generation of development scum | 1/4 | Separation | Unusable | B |
| Comparative Example 2 | Comparative Developer 2 | Generation of development scum | 1/4 | Separation | Unusable | B |
| Comparative Example 3 | Comparative Developer 3 | Poor development | 1/4 | Separation | Unusable | B |
| Comparative Example 4 | Comparative Developer 4 | Poor development | 1/4 | No problem | No problem | B |
| Comparative Example 5 | Comparative Developer 5 | Over development | 1/4 | Foaming | Unusable | B |
| Comparative Example 6 | Comparative Developer 6 | Over development | 1/4 | No problem | No problem | B |
| Comparative Example 7 | Comparative Developer 7 | Over development | 1/4 | No problem | No problem | B |
| Comparative Example 8 | Comparative Developer 8 | No problem | 1/4 | Incorporation of solvent into reclaimed water | Unusable | B |
| Comparative Example 9 | Developer 1 | No problem | 1/12 | Separation | Unusable | B |

As a result of the evaluation, as shown in Table 2, regarding Example 1 to Example 14, in which a developer defined in the invention was used and the waste liquid concentration rate was within the scope of the invention, all of the results of the Evaluation on Platemaking and the results of the Evaluations on Waste liquid concentrating step/ Reclaimed water were favorable, and the obtained reclaimed water was reclaimed water capable of being utilized in the reclaimed water supplying step described below.

On the other hand, in Comparative Example 1 to Comparative Example 9, in which the developer outside the scope of the invention was used, or the waste liquid concentration rate was outside the scope of the invention, any or all of the results of the Evaluation on Platemaking and the results of the Evaluations on Waste liquid concentrating step/ Reclaimed water were inferior.

### [Reclaimed Water Supplying Step]

Among the reclaimed water obtained through the waste liquid concentrating step described above and the succeeding reclaimed water producing step, the reclaimed water that did not cause any problem in the evaluation described above was used as reclaimed water. The reclaimed water was supplied to a replenishment water tank 80 in Fig. 1, and a required amount thereof was circulated through the replenishment water tank 80 to the developing bath of the automatic developing machine 10.

Thereafter, in Example 1 to Example 14 in which Developer 1 to Developer 14, which are defined in the invention, was used, continuous platemaking process was carried out using the developer, while supplying the reclaimed water which were obtained through the waste liquid concentrating step and the reclaimed water producing step and which satisfies the conditions of the invention, as replenishment water. As a result, in all cases, favorable platemaking was achieved in the succeeding continuous platemaking process for 1500 m² of the photosensitive planographic printing plate precursor 1, and no problems occurred in all the Evaluation on Platemaking and the Evaluation on Reclaimed water.

### [Comparative Example 10]

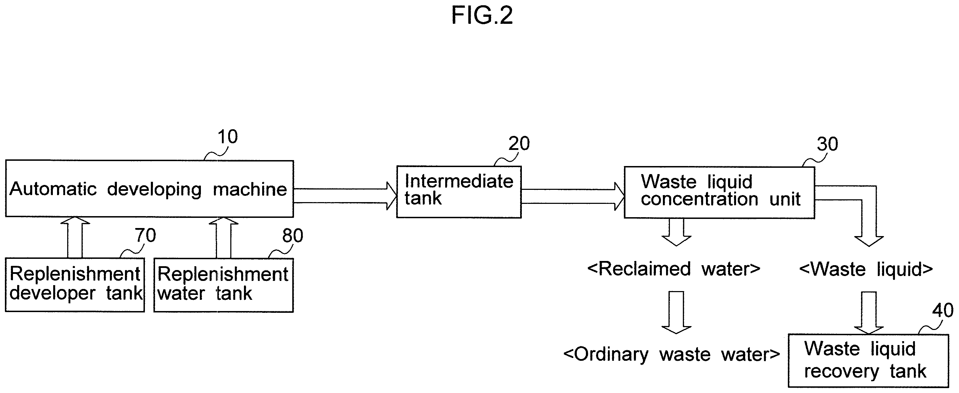

1500 m² of the planographic printing plate precursor 1 that had undergone exposure was subjected to platemaking continuously for one month in a similar manner to that in Example 13, except that the system of Fig. 2 was used instead of using the system of Fig. 1 in Example 13. In concentrating the development waste liquid after platemaking, the concentration rate of the platemaking waste liquid, namely, the ratio of the volume of the platemaking waste liquid after the concentration to the volume of the platemaking waste liquid before the concentration was adjusted to 1/12.

Benzyl alcohol was incorporated in the reclaimed water thus obtained, and therefore, the BOD value of the reclaimed water was 1000 mg/L, which exceeds the regulation value of ordinary waste water. Therefore, the obtained reclaimed water could not be supplied as replenishment water or could not be drained directly into a sewer as an ordinary waste water.

The disclosure of Japanese Patent Application No. 2013-052177 filed on March 14, 2013 is incorporated by reference herein in its entirely.

All publications, patent applications, and technical standards mentioned in this specification are herein incorporated by reference to the same extent as if such individual publication, patent application, or technical standard was specifically and individually indicated to be incorporated by reference.

### Explanation of Symbols

- 10, 90, 100, 190: Automatic developing machine
- 30: Waste liquid concentration unit
- 40: Waste liquid recovery tank
- 50: Reclaimed water tank
- 60: Distilled reclaimed water reutilization unit
- 70: Replenishment developer tank
- 80: Replenishment water tank
- 91: Developer applying means (spray pipe)
- 93: Rotating brush roll
- 191: First development section
- 192: Second development section
- 300: Development section
- 308: Developing bath (developing tank)
- 322, 326: Pair of brush rollers

## Claims

1. A method of concentrating a platemaking waste liquid generated in processing a photosensitive planographic printing plate precursor, the method comprising:
a platemaking step in which development and desensitization of a photosensitive planographic printing plate precursor, which has, on a support, an image recording layer that contains thermoplastic polymer particles and a photothermal conversion agent and which has undergone exposure with an infrared laser, are conducted in one step in an automatic developing machine, using a developer;
a waste liquid concentrating step of evaporating and concentrating a platemaking waste liquid generated in the platemaking step, using a waste liquid concentration unit, such that a ratio of a volume of the platemaking waste liquid after the concentration to a volume of the platemaking waste liquid before the concentration is from 1/2 to 1/10; and
a reclaimed water producing step of taking out steam that has been separated in the waste liquid concentrating step from the waste liquid concentration unit, and condensing the steam using a cooling means, to produce reclaimed water,
wherein the developer is a developer which contains at least one surfactant selected from the group consisting of anionic surfactants and nonionic surfactants in an amount of from 1% by mass to 10% by mass, and has a content of an organic solvent having a boiling point within a range of from 100°C to 300°C of 2% by mass or lower, but does not contain an organic solvent having a boiling point of lower than 100°C or a boiling point of higher than 300°C or, if contained, has a content thereof of 0.2% by mass or lower.

2. The method of concentrating a platemaking waste liquid generated in processing a photosensitive planographic printing plate precursor according to claim 1, wherein the developer comprises an anionic surfactant, preferably an anionic surfactant comprising a sulfonic acid salt having a diphenyl ether skeleton, or more preferably two or more types of sulfonic acid salts having diphenyl ether skeletion.

3. The method of concentrating a platemaking waste liquid generated in processing a photosensitive planographic printing plate precursor according to claim 1 or claim 2, wherein the organic solvent having a boiling point within a range of from 100°C to 300°C is ethylene glycol, and a content of ethylene glycol with respect to the developer is from 0.1 % by mass to 1.0% by mass.

4. The method of concentrating a platemaking waste liquid generated in processing a photosensitive planographic printing plate precursor according to any one of claim 1 to claim 3, wherein the developer comprises a water-soluble resin, or preferably wherein the developer comprises a water-soluble resin of dextrin, and a content of dextrin with respect to the developer is from 1.0% by mass to 5.0% by mass.

5. The method of concentrating a platemaking waste liquid generated in processing a photosensitive planographic printing plate precursor according to any one of claim 1 to claim 4, wherein a pH of the developer is from 6 to 10.

6. The method of concentrating a plate making waste liquid generated in processing a photosensitive planographic printing plate precursor according to claim 1, wherein the method is further **characterized by**
a reclaimed water supplying step of supplying the reclaimed water obtained in the reclaimed water producing step to the automatic developing machine.

7. The method of concentrating a plate making waste liquid according to claim 6, wherein the developer comprises an anionic surfactant, preferably an anionic surfactant comprising a sulfonic acid salt having a diphenyl ether skeleton, or more preferably two or more types of sulfonic acid salts having a diphenyl ether skeleton.

8. The method of concentrating a plate making waste liquid according to claim 6 or claim 7, wherein the organic solvent having a boiling point within a range of from 100°C to 300°C is ethylene glycol, and a content of ethylene glycol with respect to the developer is from 0.1% by mass to 1.0% by mass.

9. The method of concentrating a plate making waste liquid according to any one of claim 6 to claim 8, wherein the developer comprises a water-soluble resin.

10. The method of concentrating a plate making waste liquid according to any one of claim 6 to claim 9, wherein a pH of the developer is from 6 to 10.

11. The method of concentrating a plate making waste liquid according to any one of claim 6 to claim 10, comprising a planographic printing plate drying step of drying a planographic printing plate obtained through the platemaking step.

12. The method of concentrating a plate making waste liquid according to any one of claim 6 to claim 11, wherein the waste liquid concentration unit comprises a heating means.

13. The method of concentrating a plate making waste liquid according to claim 12, wherein heating is carried out under reduced pressure, using the heating means included in the waste liquid concentration unit.

14. The method of concentrating a plate making waste liquid according to claim 12 or claim 13, wherein the heating means included in the waste liquid concentration unit is a heat pump comprising a heat radiating section and a heat absorbing section, and the platemaking waste liquid is heated at the heat radiating section of the heat pump, while the steam is cooled at the heat absorbing section of the heat pump.

15. The method of concentrating a plate making waste liquid according to any one of claim 6 to claim 14, wherein the waste liquid concentrating step further comprises a concentrate collecting step of collecting a concentrate of the platemaking waste liquid, which has been concentrated by evaporation concentration, into a recovery tank, by applying pressure to the concentrate using a pump.

## Patentansprüche

1. Verfahren zum Konzentrieren einer Abfallflüssigkeit aus der Plattenherstellung, die bei der Verarbeitung von photosensitiven Flachdruckplattenvorläufern entsteht, wobei das Verfahren die folgenden Schritte umfasst:
einen Schritt zur Plattenherstellung, bei dem die Entwicklung und die Desensibilisierung eines photosensitiven Flachdruckplattenvorläufers, der auf einem Träger eine Bildaufzeichnungsschicht aufweist, die thermoplastische Polymerteilchen und ein photothermisches Umwandlungsmittel enthält, und die eine Belichtung mit einem Infrarotlaser durchlaufen hat, unter Verwendung eines Entwicklers in einem Schritt in einer automatischen Entwicklungsmaschine erfolgen;
einen Schritt zum Konzentrieren einer Abfallflüssigkeit, bei dem eine Abfallflüssigkeit aus der Plattenherstellung, die im Schritt zur Plattenherstellung entstanden ist, unter Verwendung einer Abfallflüssigkeitskonzentrationseinheit verdampft und konzentriert wird, so dass das Verhältnis des Volumens der Abfallflüssigkeit aus der Plattenherstellung nach dem Konzentrieren zum Volumen der Abfallflüssigkeit aus der Plattenherstellung vor dem Konzentrieren 1/2 bis 1/10 beträgt; und
einen Schritt zum Bilden von rückgewonnenem Wasser, bei dem Dampf, der im Schritt zum Konzentrieren von Abfallflüssigkeiten von der Abfallflüssigkeitskonzentrationseinheit abgetrennt wurde, entnommen wird und der Dampf unter Verwendung eines Kühlmittels kondensiert wird, um rückgewonnenes Wasser zu bilden.
wobei der Entwickler ein Entwickler ist, der mindestens ein Tensid, das aus der Gruppe, die aus anionischen Tensiden und nichtionischen Tensiden besteht, ausgewählt wird, in einer Menge von 1 Massenprozent bis 10 Massenprozent enthält
und ein organisches Lösungsmittel mit einem Siedepunkt innerhalb eines Bereichs von 100°C bis 300°C in einem Gehalt von 2 Massenprozent oder weniger aufweist, aber kein organisches Lösungsmittel mit einem Siedepunkt von weniger als 100°C oder einem Siedepunkt von mehr als 300°C enthält oder, falls er solches doch enthält, der Gehalt davon 0,2 Massenprozent oder weniger beträgt.

2. Verfahren zum Konzentrieren einer Abfallflüssigkeit aus der Plattenherstellung, die bei der Verarbeitung von photosensitiven Flachdruckplattenvorläufern entsteht, gemäß Anspruch 1, bei dem der Entwickler ein anionisches Tensid umfasst, das vorzugsweise ein anionisches Tensid ist, das ein Sulfonsäuresalz mit einem Diphenylethergerüst oder noch mehr bevorzugt zwei oder mehr Arten von Sulfonsäuresalzen mit einem Diphenylethergerüst umfasst.

3. Verfahren zum Konzentrieren einer Abfallflüssigkeit aus der Plattenherstellung, die bei der Verarbeitung von photosensitiven Flachdruckplattenvorläufern entsteht, gemäß Anspruch 1 oder 2, bei dem das organische Lösungsmittel mit einem Siedepunkt innerhalb eines Bereichs von 100°C bis 300°C Ethylenglycol ist und der Gehalt an Ethylenglycol bezogen auf den Entwickler 0,1 Massenprozent bis 1,0 Massenprozent beträgt.

4. Verfahren zum Konzentrieren einer Abfallflüssigkeit aus der Plattenherstellung, die bei der Verarbeitung von photosensitiven Flachdruckplattenvorläufern entsteht, gemäß einem der Ansprüche 1 bis 3, bei dem der Entwickler ein wasserlösliches Harz umfasst oder bei dem der Entwickler vorzugsweise ein wasserlösliches Dextrinharz umfasst und der Gehalt an Dextrin bezogen auf den Entwickler 1,0 Massenprozent bis 5,0 Massenprozent beträgt.

5. Verfahren zum Konzentrieren einer Abfallflüssigkeit aus der Plattenherstellung, die bei der Verarbeitung von photosensitiven Flachdruckplattenvorläufern entsteht, gemäß einem der Ansprüche 1 bis 4, bei dem der pH des Entwicklers 6 bis 10 beträgt.

6. Verfahren zum Konzentrieren einer Abfallflüssigkeit aus der Plattenherstellung, die bei der Verarbeitung von photosensitiven Flachdruckplattenvorläufern entsteht, gemäß Anspruch 1, ferner **gekennzeichnet durch** einen Schritt zur Versorgung mit rückgewonnenem Wasser, bei dem die automatische Entwicklungsmaschine mit dem rückgewonnenem Wasser, das im Schritt zum Bilden von rückgewonnenem Wasser erhalten wird, versorgt wird.

7. Verfahren zum Konzentrieren einer Abfallflüssigkeit aus der Plattenherstellung gemäß Anspruch 6, bei dem der Entwickler ein anionisches Tensid umfasst, das vorzugsweise ein anionisches Tensid ist, das ein Sulfonsäuresalz mit einem Diphenylethergerüst oder noch mehr bevorzugt zwei oder mehr Arten von Sulfonsäuresalzen mit einem Diphenylethergerüst umfasst.

8. Verfahren zum Konzentrieren einer Abfallflüssigkeit aus der Plattenherstellung gemäß Anspruch 6 oder 7, bei dem das organische Lösungsmittel mit einem Siedepunkt innerhalb eines Bereichs von 100°C bis 300°C Ethylenglycol ist und der Gehalt an Ethylenglycol bezogen auf den Entwickler 0,1 Massenprozent bis 1,0 Massenprozent beträgt.

9. Verfahren zum Konzentrieren einer Abfallflüssigkeit aus der Plattenherstellung gemäß einem der Ansprüche 6 bis 8, bei dem der Entwickler ein wasserlösliches Harz umfasst.

10. Verfahren zum Konzentrieren einer Abfallflüssigkeit aus der Plattenherstellung gemäß einem der Ansprüche 6 bis 9, bei dem der pH des Entwicklers 6 bis 10 beträgt.

11. Verfahren zum Konzentrieren einer Abfallflüssigkeit aus der Plattenherstellung gemäß einem der Ansprüche 6 bis 10, umfassend einen Schritt zum Trocknen einer Flachdruckplatte, bei dem die im Schritt zur Plattenherstellung erhaltene Flachdruckplatte getrocknet wird.

12. Verfahren zum Konzentrieren einer Abfallflüssigkeit aus der Plattenherstellung gemäß einem der Ansprüche 6 bis 11, bei dem die Abfallflüssigkeitskonzentrationseinheit ein Heizmittel umfasst.

13. Verfahren zum Konzentrieren einer Abfallflüssigkeit aus der Plattenherstellung gemäß Anspruch 12, bei dem ein Erwärmen unter Verwendung des in der Abfallflüssigkeitskonzentrationseinheit enthaltenen Heizmittels bei vermindertem Druck erfolgt.

14. Verfahren zum Konzentrieren einer Abfallflüssigkeit aus der Plattenherstellung gemäß Anspruch 12 oder 13, bei dem das in der Abfallflüssigkeitskonzentrationseinheit enthaltene Heizmittel eine Wärmepumpe ist, die einen wärmeabstrahlenden Abschnitt und einen wärmeabsorbierenden Abschnitt umfasst, und die Abfallflüssigkeit aus der Plattenherstellung im wärmeabstrahlenden Abschnitt der Wärmepumpe erwärmt wird während der Dampf im wärmeabsorbierenden Abschnitt der Wärmepumpe gekühlt wird.

15. Verfahren zum Konzentrieren einer Abfallflüssigkeit aus der Plattenherstellung gemäß einem der Ansprüche 6 bis 14, bei dem der Schritt zum Konzentrieren einer Abfallflüssigkeit ferner einen Schritt zum Sammeln des Konzentrats umfasst, bei dem das durch Verdampfen konzentrierte Konzentrat der Abfallflüssigkeit aus der Plattenherstellung durch Aufbringen von Druck auf das Konzentrat unter Verwendung einer Pumpe in einem Rückgewinnungstank gesammelt wird.

## Revendications

1. Procédé de concentration d'un déchet liquide de clichage produit au cours du traitement d'un précurseur de plaque d'impression planographique photosensible, le procédé comprenant :
une étape de clichage dans laquelle le développement et la désensibilisation d'un précurseur de plaque d'impression planographique photosensible, qui comprend, sur un support, une couche d'enregistrement d'image qui contient des particules polymères thermoplastiques et un agent de conversion photothermique et qui a subi une exposition à un laser infrarouge, sont mis en oeuvre en une seule étape dans une machine à développer automatique, à l'aide d'un développateur;
une étape de concentration de déchet liquide consistant à évaporer et à concentrer un déchet liquide de clichage produit au cours de l'étape de clichage, à l'aide d'une unité de concentration de déchet liquide, de sorte qu'un rapport d'un volume du déchet liquide de clichage après la concentration sur un volume du déchet liquide de clichage avant la concentration est de 1/2 à 1/10 ; et
une étape de production d'eau de récupération consistant à prélever, de l'unité de concentration de déchet liquide, la vapeur d'eau qui a été séparée au cours de l'étape de concentration de déchet liquide, et à condenser la vapeur d'eau à l'aide d'un moyen de refroidissement, afin de produire de l'eau de récupération,
dans lequel le développateur est un développateur qui contient au moins un agent tensioactif choisi dans le groupe constitué d'agents tensioactifs anioniques et d'agents tensioactifs non ioniques en une proportion de 1 % en masse à 10 % en masse, et a une teneur en un solvant organique, ayant un point d'ébullition situé à l'intérieur d'une plage allant de 100 °C à 300 °C, inférieure ou égale à 2 % en masse, mais ne contient pas de solvant organique ayant un point d'ébullition inférieur à 100 °C ou un point d'ébullition supérieur à 300 °C ou, le cas échéant, a une teneur en celui-ci qui est inférieure ou égale à 0,2 % en masse.

2. Procédé de concentration d'un déchet liquide de clichage produit au cours du traitement d'un précurseur de plaque d'impression planographique photosensible selon la revendication 1, dans lequel le développateur comprend un agent tensioactif anionique, de préférence un agent tensioactif anionique comprenant un sel d'acide sulfonique ayant un squelette oxyde de diphényle, ou de manière davantage préférée au moins deux types de sels d'acide sulfonique ayant un squelette oxyde de diphényle.

3. Procédé de concentration d'un déchet liquide de clichage produit au cours du traitement d'un précurseur de plaque d'impression planographique photosensible selon la revendication 1 ou la revendication 2, dans lequel le solvant organique ayant un point d'ébullition situé à l'intérieur d'une plage allant de 100 °C à 300 °C est de l'éthylène glycol, et une teneur en éthylène glycol par rapport au développateur est de 0,1 % en masse à 1,0 % en masse.

4. Procédé de concentration d'un déchet liquide de clichage produit au cours du traitement d'un précurseur de plaque d'impression planographique photosensible selon l'une quelconque de la revendication 1 à la revendication 3, dans lequel le développateur comprend une résine hydrosoluble, ou de préférence dans lequel le développateur comprend une résine de dextrine hydrosoluble, et une teneur en dextrine par rapport au développateur est de 1,0 % en masse à 5,0 % en masse.

5. Procédé de concentration d'un déchet liquide de clichage produit au cours du traitement d'un précurseur de plaque d'impression planographique photosensible selon l'une quelconque de la revendication 1 à la revendication 4, dans lequel un pH du développateur est de 6 à 10.

6. Procédé de concentration d'un déchet liquide de clichage produit au cours du traitement d'un précurseur de plaque d'impression planographique photosensible selon la revendication 1, dans lequel ledit procédé est en outre **caractérisé par** une étape d'alimentation en eau de récupération consistant à alimenter la machine à développer automatique en eau de récupération obtenue au cours de l'étape de production d'eau de récupération.

7. Procédé de concentration d'un déchet liquide de clichage selon la revendication 6, dans lequel le développateur comprend un agent tensioactif anionique, de préférence un agent tensioactif anionique comprenant un sel d'acide sulfonique ayant un squelette oxyde de diphényle, ou de manière davantage préférée au moins deux types de sels d'acide sulfonique ayant un squelette oxyde de diphényle.

8. Procédé de concentration d'un déchet liquide de clichage selon la revendication 6 ou la revendication 7, dans lequel le solvant organique ayant un point d'ébullition situé à l'intérieur d'une plage allant de 100 °C à 300 °C est de l'éthylène glycol, et une teneur en éthylène glycol par rapport au développateur est de 0,1 % en masse à 1,0 % en masse.

9. Procédé de concentration d'un déchet liquide de clichage selon l'une quelconque de la revendication 6 à la revendication 8, dans lequel le développateur comprend une résine hydrosoluble.

10. Procédé de concentration d'un déchet liquide de clichage selon l'une quelconque de la revendication 6 à la revendication 9, dans lequel un pH du développateur est de 6 à 10.

11. Procédé de concentration d'un déchet liquide de clichage selon l'une quelconque de la revendication 6 à la revendication 10, comprenant une étape de séchage de plaque d'impression planographique consistant à sécher une plaque d'impression planographique obtenue au cours de l'étape de clichage.

12. Procédé de concentration d'un déchet liquide de clichage selon l'une quelconque de la revendication 6 à la revendication 11, dans lequel l'unité de concentration de déchet liquide comprend un moyen de chauffage.

13. Procédé de concentration d'un déchet liquide de clichage selon la revendication 12, dans lequel le chauffage est mis en oeuvre sous une pression réduite, à l'aide du moyen de chauffage inclus dans l'unité de concentration de déchet liquide.

14. Procédé de concentration d'un déchet liquide de clichage selon la revendication 12 ou la revendication 13, dans lequel le moyen de chauffage inclus dans l'unité de concentration de déchet liquide est une pompe à chaleur comprenant une section de rayonnement de chaleur et une section d'absorption de chaleur, et le déchet liquide de clichage est chauffé au niveau de la section de rayonnement de chaleur de la pompe à chaleur, tandis que la vapeur d'eau est refroidie au niveau de la section d'absorption de chaleur de la pompe à chaleur.

15. Procédé de concentration d'un déchet liquide de clichage selon l'une quelconque de la revendication 6 à la revendication 14, dans lequel l'étape de concentration de déchet liquide comprend en outre une étape de collecte de concentré consistant à collecter un concentré du déchet liquide de clichage, qui a été concentré par concentration par évaporation, dans un réservoir de récupération, par application d'une pression au concentré à l'aide d'une pompe.
